# EUROPÄISCHE PATENTSCHRIFT

(11) **EP 1 421 629 B1**
(45) Veröffentlichungstag und Bekanntmachung des Hinweises auf die Patenterteilung: **05.12.2007**
(21) Anmeldenummer: 02764862.5
(22) Anmeldetag: 28.08.2002
(51) Int. Cl.: H01L 31/0224, H01L 31/0236, H01L 31/0352

(54) **SOLARZELLE SOWIE VERFAHREN ZUR HERSTELLUNG EINER SOLCHEN**
SOLAR CELL AND METHOD FOR PRODUCTION THEREOF
CELLULE SOLAIRE ET PROCEDE DE FABRICATION DE LADITE CELLULE

(30) Priorität: 31.08.2001 DE 10142481
(43) Veröffentlichungstag der Anmeldung: 26.05.2004
(73) Patentinhaber: Hezel, Rudolf, 31789 Hameln (DE)
(72) Erfinder: Hezel, Rudolf, 31789 Hameln (DE)
(74) Vertreter: Stoffregen, Hans-Herbert
(86) Internationale Anmeldenummer: PCT/EP2002/009578
(87) Internationale Veröffentlichungsnummer: WO 2003/021688

(56) Entgegenhaltungen:
- US-A- 4 200 472
- US-A- 5 449 626
- US-B1- 6 172 297
- ZHOU C Z ET AL: "21.9% efficient silicon bifacial solar cells" CONFERENCE RECORD OF THE 26TH IEEE PHOTOVOLTAIC SPECIALISTS CONFERENCE - 1997. PVSC '97. ANAHEIM, CA, SEPT. 29 - OCT. 3, 1997, IEEE PHOTOVOLTAIC SPECIALISTS CONFERENCE, NEW YORK, NY: IEEE, US, 29. September 1997 (1997-09-29), Seiten 287-290, XP010267783 ISBN: 0-7803-3767-0

## Beschreibung

Die Erfindung bezieht sich auf eine Solarzelle umfassend ein Halbleitersubstrat mit ersten und zweiten Kontakten zum Sammeln und Ableiten von durch einfallende Strahlungsenergie in dem Halbleitersubstrat erzeugten Minoritäts- und Strahlungsenergie in dem Halbleitersubstrat erzeugten Minoritäts- und Majoritätsladungsträgern, wobei zumindest bereichsweise rückseitige Fläche des Halbleitersubstrats parallel verlaufende, erste Gräben begrenzende linien- bzw. stegartige Erhebungen mit jeweils erster und zweiter Längsflanke aufweist, wobei die ersten und zweiten Kontakte auf der rückseitigen Fläche des Halbleitersubstrats beabstandet zueinander angeordnet sind. Ferner nimmt die Erfindung. Bezug auf ein Verfahren zur Herstellung einer Solarzelle, umfassend ein Halbleitersubstrat mit Vorder- und Rückseite, in welchem durch einfallende Strahlungsenergie Minoritäts- und Majoritätsladungsträger erzeugt werden, die über streifen- oder stegförmige erste und zweite Längsflanken aufweisende, erste Gräben begrenzende Erhebungen der rückseitigen Fläche Halbleitersubstrats verlaufende erste und zweite Kontakte gesammelt und abgeleitet werden, wobei die ersten und/oder zweiten elektrischen Kontakte unmittelbar auf der rückseitigen Fläche aufgebracht werden oder nach ganzflächigem oder weitgehend ganzflächigem Abdecken der rückseitigen Fläche mit einer Passivierungsschicht und gegebenenfalls Entfernen von Bereichen der Passivienmgsschicht und auf so freigelegte Bereiche des Halbleitersubstrats die ersten und zweiten elektrischen Kontakte aufgebracht werden.

Die überwiegende Zahl der derzeit eingesetzten Solarzellen besteht gewöhnlich aus einem Halbleiterkörper eines Leitungstyps (z.B. p-leitend), in dem an der Oberfläche ein Gebiet des entgegengesetzten Leitungstyps (z.B. n-leitend) erzeugt wird und auf beiden Seiten des Halbleiterkörpers elektrische Kontakte angebracht sind. Die durch das einfallende Licht erzeugten Elektron-Lochpaare (Minoritäts-Majoritätsladungsträger) werden im elektrischen Feld des p-n Überganges getrennt, die Elektronen wandern zum n-Gebiet, die Löcher zum p-Gebiet, wo sie jeweils über Metallkontakte abfließen. Auf der Vorderseite sind diese Metallkontakte in Gitterform ausgeführt, um den Lichteinfall zu ermöglichen.

Um die Lichtabschattung durch diese in Streifenform ausgeführten Metallfinger weitgehend zu eliminieren und die Verbindung der Solarzellen wirtschaftlicher zu gestalten, ist es bekannt, auch den Vorderseitenkontakt rückseitig anzubringen und somit beide Ladungsträgerarten an der dem Licht abgewandten Seite zu sammeln (US 4,315,097). Wegen der äußerst komplexen Technologie werden diese sogenannten IBC (Interdigitated Back Contact) Solarzellen hauptsächlich für hochkonzentriertes Licht, also für sehr hohe Stromdichten verwendet (M.D. Lammert, R.J. Schwartz, "The Interdigitated Back Contact Solar Cell. A Silicon Solar Cell for Use in Concentrated Sunlight", IEEE Transactions on Electron Devices, Vol. ED-24, No. 4, S. 337 - 342 (1977)).

Der IBC Zelle sehr ähnlich ist die Punktkontakt (PC)-Solarzelle (R.M. Swanson, Solar Cells, Vol. 17, No. 1, S. 85 - 118 (1986)).

Eine andere Solarzelle mit beiden Kontakten auf einer Seite des Halbleiterkörpers wird in der DE 41 43 083 A1 (=EP 0 548 863 B1) beschrieben.

Aus der US 4,376,872 ist eine Solarzelle mit diskreten, Spannung erzeugenden Bereichen bekannt, die in einem Einkristall ausgebildet sind. Die Zellen weisen dotierte Bereiche unterschiedlicher Leitfähigkeit auf, die durch V-förmige Gräben getrennt sind, deren Flanken zur Erzielung gewünschter Leitfähigkeit mit Ionen bombardiert werden. Hierzu wird das Einkristallsubstrat derart auf eine Ionenquelle ausgerichtet, dass allein die zu dotierte Flanke dem Ionenstrahl ausgesetzt ist. Nach Dotieren der Flanken wird eine Metallschicht auf den Flanken der Gräben aufgetragen, die die Flanken vollständig abdecken. Die einzelnen Einheiten sind in Serie verschaltet.

Der US 4,295,002 ist eine Tandem-Solarzelle zu entnehmen, die auf beiden Seiten trapezoidförmige in Serie verschaltete Solarzellenbereiche aus Si aufweist, deren Flanken aus n⁺-GaP- bzw. p⁺-GaP-Schichten bestehen. Außenseitig sind die gegenüberliegenden n⁺-GaP- und p⁺-GaP-Schichten mit Ausnahme eines schmalen Scheitelbereichs vollständig mit einer Metallschicht abgedeckt. Ferner erstreckt sich entlang des Scheitels der Solarzellenbereiche eine SiO₂-Sicht, die außenseitig mit einer Metallschicht abgedeckt ist.

C.Z. Znou et al., 26th PVSC, Sept. 30- Oct. 3, 1997, Anaheim, CA, pages 287-290 offenbart eine Solarzelle mit den Merkmalen des Oberbegriffs von Anspruch 1.

Der vorliegenden Erfindung liegt das Problem zu Grunde, eine Solarzelle sowie ein Verfahren der eingangs genannten Art so weiterzubilden, dass eine einfach herzustellende Struktur der Solarzelle bei gleichzeitiger Erzielung eines hohen Wirkungsgrades möglich ist. Insbesondere soll ein einfaches quasi selbst justierendes Anordnen der die Majoritäts- und Minoritätsladungsträger sammelnden ersten und zweiten Kontakte erfolgen können. Dabei sollen die Kontakte zu einer den Wirkungsgrad der Solarzelle verschlechternden Abschattung nicht führen.

Erfingdungsgemäß wird das Problem im Wesentlichen durch eine Solarzelle der eingangs genannten Art dadurch gelöst, dass die erste und die zweite Längsflanke der Erhebung über einen parallel oder in etwa parallel zur von dem Halbleitersubstrat aufgespannten Ebene verlaufenden Außenabschnitt ineinander übergehen, dass aufeinander folgende Erhebungen einen Graben mit Grabenboden begrenzen, dass auf zumindest einigen der Erhebungen sich die ersten Kontakte auf den ersten Längsflanken der Erhebungen und die zweiten Kontakte auf den zweiten Längsflanken der Erhebungen erstrecken und dass die ersten und zweiten Kontakte zueinander sowohl graben- als auch außenabschnittsseitig zueinander beabstandet sind.

Die erfindungsgemäße Lehre wird durch ein System von auf den Flanken der rückseitig verlaufenden Erhebungen angeordneten Kontakten realisiert, die auch als Emitterkontakte für das Sammeln der Minoritätsleitungsträger und als Basiskontakte für das Sammeln der Majoritätsladungsträger bezeichnet werden können. Die Verwirklichung der Anordnung der Kontakte auf den Längsflanken der auf rückseitiger Fläche des Halbleitersubstrats sich erstreckenden linienförmigen Erhebungen ist dabei nicht auf einen bestimmten Solarzellentyp begrenzt. Eine Realisierung kann vielmehr sowohl auf durch Dotierung erzeugte p-n-Übergänge und Heterostrukturen als auch auf der Induzierung eines elektrischen Feldes durch ein Metall oder durch oberflächliche Isolatorladungen basieren. Das Halbleitermaterial der Solarzelle, n- oder p-leitend, kann einkristallin, polykristallin oder amorph oder ein Element oder ein Verbindungshalbleiter sein. Für den Fall des kristallinen Siliziums sollte neben einer Bor- und Phosphordotierung auch eine Dotierung mit Gallium, Indium oder Aluminium verwendet werden. Der Einsatz von Dünnschichthalbleitern wie Kupfer-Indium-Selenid bzw. Sulfid, Kadmiumtellurid und Gallium-Arsenid ist gleichfalls möglich.

Auch kann das durch eine rückseitige Doppel-Kontaktgitterstruktur einfallende Licht (Bifacial-Solarzelle) ausgenutzt und schließlich eine einfache doppelseitig beleuchtbare und doppelseitig Minoritätsladungsträger sammelnde Solarzelle zur Verfügung gestellt werden. Letztere dient sowohl zur bestmöglichen Ausnutzung des Umgebungsstreulichtes wie auch zur sehr effektiven Sammlung der lichterzeugten Ladungsträger, insbesondere bei Vorliegen eines billigeren Halbleitersubstrates mit reduzierter Diffusionslänge der Minoritätsladungsträger. In speziellen Fällen kann die Doppel-Kontaktgitterstruktur statt auf der Rückseite auch auf der dem direkten Sonnenlicht zugewandten Vorderseite angebracht werden. Dies ist insbesondere für DünnschichtSolarzellen vorteilhaft, bei denen sich die dünne Halbleiterschicht auf einem Fremdsubstrat befindet und durch die erfindungsgemäße Anordnung die meist schwierige Einfügung eines Rückseitenkontaktes zwischen Halbleiter und Fremdsubstrat vermieden wird (S. Roberts et al. Proc. 2nd WCPEC (1998), S. 1449)).

Erfindungsgemäß ist vorgesehen, dass der erste Kontakt bereichsweise auf der einen ersten Längsflanke und der zweite Kontakt bereichsweise auf der gegenüberliegenden zweiten Längsflanke der selben Erhebung der Halbleitersubstratfläche angeordnet sind, wobei sich der jeweilige Kontakt bzw. dessen Metallisierung auch noch in geringem Maße über die eckigen oder abgerundeten Kanten des vorgesehenen plateauartigen Bereichs der Erhebungen erstrecken kann, der in die Längsflanken übergeht. Allerdings muss in den aneinander grenzenden Bereichen ein ausreichender Abstand zwischen dem ersten und dem zweiten Kontakt gewährleistet sein, um Kurzschlüsse zu vermeiden.

Die Erhebungen begrenzen Gräben, die grundsätzlich jeweils einen Grabenboden aufweisen, der parallel zu der von dem Halbleitersubstrat aufgespannten Ebene verläuft. Dieser Bereich ist durch einen elektrischen Kontakt nicht abgedeckt, so dass Licht eintreten kann. Kurzschlüsse zwischen den Kontakten sind gleichfalls ausgeschlossen.

Insbesondere ist vorgesehen, dass die Erhebungen im Schnitt eine U-, V- oder Sägezahn-geometrie aufweisen. Der erste bzw. zweite Kontakt erstreckt sich vorzugsweise bis hin zum äußeren Längsrand der ersten bzw. der zweiten Längsflanke der Erhebung.

Ein wesentlicher Vorteil der erfindungsgemäßen Solarzelle, die als Back-OECO (Obliquely-Evaporated-Contact) oder Rear-OECO Solarzelle bezeichnet werden kann, ist dadurch gegeben, dass aufgrund der Erhebungen die Kontakte beispielsweise durch Schrägaufdampfung im Vakuum völlig masken- und justierfrei aufgebracht und definiert werden können. Insbesondere ist die gegenseitige Trennung der beiden Kontaktfinger zur Vermeidung von Kurzschlüssen automatisch durch die aufgrund der Schrägaufdampfung auf einfache Weise metallisierungsfrei zu gestaltende Oberseite der Erhebungen gewährleistet und muss nicht, wie bei den bekannten beschriebenen rückseitig sammelnden Solarzellen (IBC oder Punktkontakt) durch insbesondere bei größeren Flächen äußerst schwierig durchzuführende und aufwendige photolithografische Methoden erreicht werden. Der Abstand der beiden Kontakte bzw. deren Metallisierung untereinander kann auf einfache Art durch die Breite der Erhebungen eingestellt werden, während die Zahl der Kontakte durch den Abstand der Erhebungen und damit deren Dichte variierbar ist. Bei der Schrägaufdampfung der Materialien für die Kontakte im Vakuum wird das Prinzip der Selbstabschattung angewendet. Hoher Scheibendurchsatz, sehr gute Metallausnutzung und einfache Handhabung sind die wesentlichen Vorteile dieser Methode gegenüber der herkömmlichen Vakuumaufdampfung (Hezel, R Proc. 13th European PVSEC, Nice 1995, S. 115).

Ein weiterer Vorteil der erfindungsgemäßen Lehre besteht darin, dass durch Ausbildung der Erhebung durch die Einbringung von Gräben auf der Substratrückseite mit deren Tiefe gleichzeitig die verbleibende Halbleitersubstratdicke festgelegt werden kann.

Zur effizienten Sammlung der Ladungsträger auf der Rückseite muss diese, je nach Materialqualität, d.h. Diffusionslänge der Minoritätsladungsträger, unterschiedlich ausgelegt werden. Die Stützfunktion der Erhebungen erlaubt es, die Halbleiterdicke ohne Bruchgefahr sehr dünn zu machen, was insbesondere für billiges Material mit geringer Ladungsträgerlebensdauer von Bedeutung ist.

Die Bedeutung der Erfindung liegt in der Anordnung der Metallkontakte, deren exakter Trennung voneinander und in der Aneinanderreihung der Solarzelleneinheiten. Die jeweilige Einheit mit vorzugsweise senkrechten Flanken und vorzugsweise Metallbereichen im oberen Teil zu beiden Seiten der Erhebungen getrennt durch breite nicht metallisierte Gräben, die aktiv zur Sammlung von Ladungsträgern genutzt werden, da sie vorzugsweise mit einer diffundierten n⁺-bzw Inversionsschicht versehen sind. Die Gräben, die auch nur mit einer Passivierschicht bedeckt sein können, besitzen ganz oder teilweise eine Bodenfläche, die parallel zu der vom Halbleitersubstrat aufgespannten Ebene verläuft. Die Tiefe der Gräben bestimmt weitgehend die Funktion der rückseitensammelnden Solarzelle, da die Minoritätsträger durch die Basis zur Rückseite diffundieren müssen. Diese Tiefe und damit weitgehend die Dicke der Basis kann erfindungsgemäß durch die Strukturierung der Rückseite erfolgen und damit exakt auf die Diffusionslänge des jeweiligen Halbleitermaterials eingestellt werden.

In Weiterbildung der Erfindung ist vorgesehen, dass das Halbleitersubstrat in seiner an den ersten und/der den zweiten Kontakt angrenzenden Oberfläche durch z. B. Diffusion, Legieren oder Ionen-Implantation hochdotiert und/oder invertiert ist und/oder einen Heteroübergang aufweist.

Der die Minoritätsladungsträger sammelnde erste Kontakt (Emitterkontakt) kann ein Metall-/Halbleiterkontakt und/oder ein MIS (Metall-Isolator-Halbleiterkontakt) sein.

Als Majoritätsleitungsträger sammelnder zweiter Kontakt (Basiskontakt) kann ein unmittelbar auf dem Halbleitersubstrat aufgebrachter Metallkontakt und/oder ein auf hochdotiertem Halbleitersubstrat aufgebrachter Metallkontakt sein.

Mit anderen Worten kann die Halbleiteroberfläche außerhalb der Kontakte a) hochdotiert (vorzugsweise durch Diffusion oder Ionenimplantation; Beispiel n⁺ Schicht bei p-Halbleiter), b) invertiert (Elektronen-Inversionsschicht bei p-Si), c) einen Heteroübergang besitzen (z.B. a-Si / p-Si) oder d) nur durch eine entsprechende Oberflächenschicht passiviert Sein.

Als Minoritätsladungsträgerkontakte können eingesetzt werden: a) Metall-Halbleiterkontakte, wobei vorzugsweise der Halbleiter im Kontaktbereich hochdotiert ist (n⁺ bei p-Si), b) entsprechende Metall-Isolator-Halbleiterkontakte (MIS), wobei der Halbleiter unter dem Metall hochdotiert sein kann (MI n⁺p) oder nur durch ein geeignetes Metall aufgrund der Austrittsarbeitsdifferenz (vorzugsweise A1 bei p-Si) invertiert wird (R. Hezel, R. Meyer, A. Metz, Solar Energy Materials and Solar Cells 65, S. 311 (2001)).

Als Majoritätsladungsträgerkontakt können beispielsweise Metallkontakte direkt auf dem Halbleiter, z. B. Al-p-Si, Ti-Pd-Ag-p-Si oder Metallkontakte auf hochdotiertem Halbleiter (z.B. Al-p⁺-p-Si) verwendet werden, wobei das vorzugsweise als lokales "Back-Surface-Field" (BSF) dienende p⁺ Gebiet durch Diffusion, Ionenimplantation (z.B. von Bor) oder auch durch Legieren des Al mit dem Silizium erzeugt werden kann ("A1 BSF"). Für den Legierungsprozess kann erfindungsgemäß eine unter einem flachen Winkel (vorzugsweise 1° - 30°) zur Halbleiteroberfläche erfolgende Laser- oder Lampenbestrablung unter Ausnutzung des Abschattungseffektes herangezogen werden. Damit wird gezielt nur der Kontaktbereich erhitzt.

Auf diese Weise kann auch die Bildung des zweiten Kontaktes vereinfacht werden, indem man beispielsweise Aluminium-Finger durch Schrägaufdampfen auf die Passivierungsschicht aufbringt und mit dem Laser lokal erhitzt. Damit durchdringt das Aluminium die Passivierungsschicht und bildet einen ohmschen Kontakt zum Halbleitersubstrat

Nach einer Weiterbildung der Erfindung erstreckt sich über die gesamte rückseitige Fläche des Halbleitersubstrats einschließlich der Erhebungen, also sowohl über die Halbleiter als auch die ersten und zweiten Kontakte ein Passivierungsmaterial, so dass die durch das Licht erzeugten Ladungsträger direkt zu den ersten und zweiten Kontakten auf der Rückseite diffundieren.

Dabei kann nach einer Weiterbildung der Erfindung die Passivierungsschicht aus einer Doppel- bzw. Mehrfachschicht mit substratseitig verlaufender a-Si- wie a-Si:H-Schicht bestehen, über der zumindest eine Schicht aus vorzugsweise Plasma-SiN, SiN oder SiO₂ angeordnet ist. Insbesondere sollte die Passivierungsschicht mittelbar oder unmittelbar einen Ladungsträgertransport zwischen erstem und zweitem Kontakt unterbinden oder im Wesentlichen unterbinden.

In einer weiteren Ausgestaltung wird an der Halbleiteroberfläche als sogenannte Emitterschicht eine hochdotierte n-Schicht (n⁺) bzw. durch positive Ladungen in der Passivierungsschicht eine n-leitende Inversionsschicht (bzw. ein Heteroübergang) erzeugt, entlang der die Minoritätsladungsträger zu den ersten Kontakten fließen können.

Gemäß einem weiteren Vorschlag wird erfindungsgemäß zuerst ganzflächig das Passivierungsmaterial aufgebracht, um sodann die ersten und zweiten Kontakte auf der die Erhebungen aufweisenden Halbleitersubstratfläche so anzuordnen, dass die ersten und zweiten Kontakte zumindest bereichsweise auf zuvor mit Passivierungsmaterial abgedeckten und sodann von diesem freigelegten Außenabschnitten der Erhebungen unmittelbar oder auf einer Isolatorschicht angeordnet sind und dass sich entlang der Halbleitersubstratfläche entweder nur eine Passivierungsschicht ohne Erzeugung einer Querleitfähigkeit, eine leitende Inversionsschicht oder eine vorzugsweise durch Diffusion oder Ionenimplantation erzeugte hochdotierte n⁺ Schicht im Falle eines p-dotierten Halbleitersubstrats erstreckt.

Die Kontakte sind linienförmig im gesamten Längsflankenbereich, vorzugsweise jedoch im oberen Teil zu beiden Seiten der Erhebungen angeordnet, wobei das Metall teils auf dem Halbleiter direkt und teils auf der Passivierungsschicht verlaufen kann.

Die Halbleiteroberfläche kann auch im gesamten Bereich zusätzlich mit einer Textur wie kleineren Pyramiden versehen sein, von deren Spitzen im Kontaktbereich der Erhebungen Passivierungsschicht und teilweise Halbleitermaterial entfernt werden. Darüber werden durch Schrägaufdampfen Metallkontakte aufgebracht. Im Gegensatz zu den zuvor beschriebenen reinen Linienkontakten handelt es sich um ein durch vorzugsweise eine Inversionsschicht oder n⁺ Schicht verbundenes Punktkontaktsystem, welches vom linienförmigen Kontakt (Metallfinger) überdeckt wird. Die Punktkontakte besitzen eine quadratische Form und können zur Sammlung von Minoritäts- und Majoritätsladungsträger verwendet werden.

Um sicherzustellen, dass im Wesentlichen sämtliche Minoritätsladungsträger über die als Emitterschicht bezeichnete Minoritätsladungsträgerableitschicht zu den ersten Kontakten; als den die Minoritätsladungsträger sammelnden Kontakten oder Emitterkontakten gelangen, sieht eine hervorzuhebende Ausgestaltung der Erfindung vor, dass die Erhebungen in ihrer halbleitersubstratseitigen Basis eine Breite B aufweisen, die maximal doppelter Diffusionslänge der Minoritätsladungsträger in dem Halbleitersubstrat ist. Somit bildet die Basis quasi ein Richtventil für die Minoritätsladungsträger, über die diese zu den ersten Kontakten geführt und von den zweiten Kontakten ferngehalten werden. Selbstverständlich sind auch andere Dimensionierungen möglich.

Ganz allgemein sollte die Geometrie der Erhebung derart gewählt sein, dass die von einer Erhebung ausgehenden ersten und zweiten Kontakte mit ihren jeweiligen erhebungsbasisseitigen Längsrändern eine erste Ebene aufspannen und dass zwischen der ersten Ebene und der halbleiterschichtseitigen Basis der Erhebung eine Schnittebene verläuft, die parallel zu der von dem Halbleitersubstrat aufgespannten Ebene verläuft die Längsflanken schneidet und eine Breite B aufweist, die kleiner oder gleich doppelter Diffussionslänge der Minoritätsladungsträger in dem Halbleitersubstrat ist.

Insbesondere sollte der Abstand zwischen basisseitigem Rand des zweiten Kontaktes und Basis der Erhebung größer als halbe Breite der Basis sein. Durch diese Maßnahmen wird dann, wenn entlang der Oberfläche der Erhebung eine Emitterschicht verläuft, sichergestellt, dass auch in den Erhebungen erzeugte Majoriäts-/Minontätsladungsträgerpaare derart gezielt weggeführt werden, dass die Minoritätsladungsträger entweder unmittelbar zu dem ersten Kontakt oder über die Emitterschicht zu diesem abgeleitet werden.

Ein wesentliches Merkmal der Erfindung besteht darin, dass am basisseitigen Ansatz der Erhebungen an beiden Flanken sich eine n⁺- bzw. Inversionsschicht befindet, welche die Minoritätsladungsträger absaugt, so dass sie nicht zu dem tiefer liegenden p⁺-Kontakt (Majoritätsträgerkontakt) diffundieren und dort rekombinieren können. Der p⁺-Kontakt ist somit abgeschirmt. Diese erfindungsgemäße Ausgestaltung bewirkt sowohl eine Erhöhung des Wirkungsgrades als auch eine mögliche Prozessvereinfachung, indem auf eine p⁺ Dotierung unter dem Metall (local back surface field) verzichtet werden kann.

Ein Verfahren der eingangs genannten Art zeichnet sich dadurch aus, dass die ersten Gräben der Rückseite mit Grabenböden und die Erhebungen der Rückseite mit Außenabschnitten ausgebildet werden, die parallel zur von dem Halbleitersubstrat aufgespannten Ebene verlaufen, dass auf zumindest einigen der Erhebungen die ersten elektrischen Kontakte auf den ersten Längsflanken der Erhebungen und die zweiten elektrischen Kontakte auf den zweiten Längsflanken der Erhebungen derart aufgebracht werden, dass die ersten und zweiten elektrischen Kontakte zueinander sowohl grabenbodenseitig als auch außenabschnittsseitig zueinander beabstandet sind. Insbesondere wird der erste und/oder der zweite Kontakt durch Aufdampfen von Material unter einem Winkel α zur von von dem Halbleitersubstrat aufgespannter Ebene ausgehenden Normalen aufgebracht werden, wobei der Aufdampfwinkel α beträgt α ≠ 0° und α ≠ 90°. Dabei werden die ersten Kontakte in einem ersten Schrägaufdampfprozessschritt und sodann die zweiten Kontakte in einem zweiten Aufdampfprozessschritt ausgebildet oder umgekehrt. Der Winkel α beträgt vorzugsweise, 89° > α > 60°. Grundsätzlich werden jedoch zunächst die Majoritätsladungsträger sammelnden Kontakte (bei einem p-Substrat also die die Löcher sammelnden ohmschen Kontakte) und anschließend die Minoritätsladungsträger sammelnden Kontakte hergestellt

Zur Dotierung der ersten und/oder der zweiten Längsflanke insbesondere unterhalb auf dieser auszubildendem ersten und/oder zweiten Kontakt werden maskierungsfrei Ionen derart implantiert, dass diese unter einem Auftreffwinkel β zur Normalen auftreffen, wobei der Auftreffwinkel β beträgt β ≠ 0° und β ≠ 90°. Der Winkel β beläuft sich vorzugsweise auf 89° > β > 60°.

Des Weiteren sieht die Erfindung vor, dass die rückseitige Fläche des Halbleitersubstrats ganzflächig oder im Wesentlichen ganzflächig mit einer Passivierungsschicht abgedeckt wird und sodann vorzugsweise durch chemisch mechanisches Polieren zumindest die Passivierungsschicht und gegebenenfalls Halbleitermaterial im freien Längsrandbereich der Erhebungen sowie von deren insbesondere plateauartigen äußeren Bereichen abgetragen werden.

Nach Entfernen der Passivierungsschicht können sodann die ersten und zweiten Kontakte ausgebildet werden, wobei gegebenenfalls der erste und/oder der zweite Kontakt erhebungsbasisseitig bereichsweise auf der Passivierungsschicht verläuft.

Sei es zum Trennen der entlang der Frontflächen der Erhebungen verlaufenden ersten und zweiten Kontakte, sei es zum Abtragen von Passivierungsschichtmaterial auf den Erhebungen, sei es im Bereich freier äußerer Längsränder der Erhebungen, so wird hierzu nach einem eigenerfinderischen Vorschlag, der für Halbleiterelemente ganz allgemein anwendbar ist, vorgeschlagen, dass beim Polieren, insbesondere mechanisch-chemischen Polieren der rückseitigen Fläche des Halbleitersubstrats ein translatorisch sich bewegendes oder ein rotierendes Polierelement wie Polierteller verwendet wird, wobei das Halbleitersubstrat derart auf das Polierelement ausgerichtet wird, dass die Erhebungen mit ihren Längsrichtungen in Bewegungsrichtung des Polierelementes ausgerichtet werden. Im Falle eines rotierenden Polierelementes oder eines translatorisch sich bewegenden Polierelementes sollten die Längsachsen der Erhebungen zur Bewegungsrichtung des Polierelementes einen Winkel γ mit insbesondere 1° ≤ γ ≤ 30° einschließen. Eine parallele Ausrichtung ist jedoch gleichfalls möglich.

Nach hervorzuhebenden Vorschlägen der Erfindung ist demnach vorgesehen, dass die ersten und zweiten Kontakte entweder in ihrer ganzen Breite oder zumindest bereichsweise auf zuvor mit Passivierungsmaterial abgedeckten und sodann von diesem freigelegten Abschnitten der Erhebungen unmittelbar oder auf einer Isolatorschicht angeordnet sind und dass die Halbleitersubstratfläche entweder nur durch eine Passivierungschicht (SiO₂, SiN, Al₂O₃, a-Si, a-Si:H, etc.) abgedeckt ist oder dass sich wahlweise zusätzlich entlang der Halbleitersubstratfläche eine die Minoritätsladungsträger zu den Kontakten leitende dotierte Schicht, eine Heteroschicht oder eine Inversionsschicht erstreckt, die allgemein als Minoritätsladungsträgerleit- oder Emitterschicht bezeichnet werden kann.

Weitere Einzelheiten, Vorteile und Merkmale der vorliegenden Erfindung ergeben sich nicht nur aus den Ansprüchen, den diesen zu entnehmenden Merkmalen - für sich und / oder in Kombination -, sondern auch aus der nachfolgenden Beschreibung eines den Zeichnungen zu entnehmenden bevorzugten Ausführungsbeispiels.

Es zeigen:
- Fig. 1: eine Prinzipdarstellung einer Solarzelle mit rückseitigen Erhebungen,
- Fig. 2 bis 5: Ausgestaltungen rückseitiger Erhebungen einer Solarzelle,
- Fig. 6: eine erste Ausführungsform von Rückseitenkontakten einer Solarzelle,
- Fig. 7: eine zweite Ausführungsform von Rückseitenkontakten einer Solarzelle,
- Fig. 8: eine dritte Ausführungsform von Rückseitenkontakten einer Solarzelle,
- Fig. 9: einen Ausschnitt einer rückseitigen Erhebung einer Solarzelle mit einem Kontakt und
- Fig. 10: eine rückseitige Erhebung einer Solarzelle mit Texturierung.

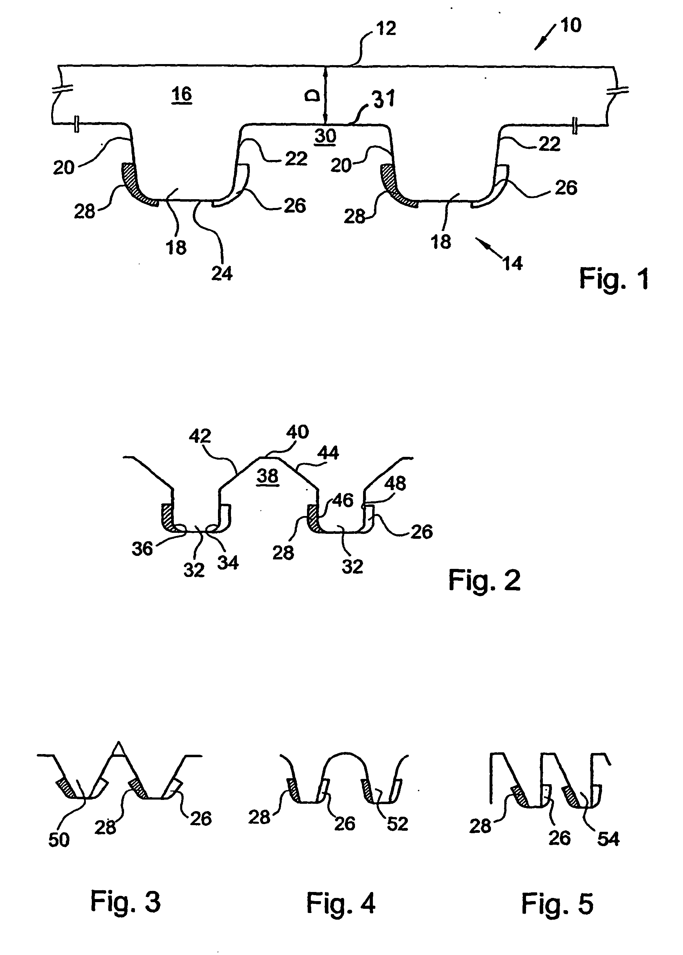

Den Figuren 1 bis 10 sind verschiedene Ausführungsformen und -gestaltungen von Solarzellen zu entnehmen, bei denen rückseitig sowohl die Minoritäts- als auch die Majoritätsladungsträger gesammelt werden.

Die erfindungsgemäße Lehre ist dabei für Solarzellen ganz allgemein anwendbar. Dabei soll eine Realisierung z.B. sowohl auf durch Dotierung erzeugten p-n-Übergängen und Heterostrukturen als auch auf der Influenzierung eines elektrischen Feldes durch ein Metall oder durch oberflächliche Isolatorladungen basieren können. Halbleitermaterialien, die in Frage kommen, sind n- oder p-leitende einkristalline, polykristallin oder amorphe Materialien und Element- oder Verbindungshalbleiter. Dabei sollte für den Fall des kristallinen Siliziums neben einer Bor- und Phosphordotierung auch eine Dotierung mit Gallium, Indium oder Aluminium Verwendung finden. Der Einsatz von Dünnschicht-Halbleitern wie Kupfer-Indium-Selenid bzw. -Sulfid, Kadmiumtellurid- und Gallium-Arsenid ist gleichfalls möglich.

Erfindungsgemäß ist dabei vorgesehen, dass die die Minoritäts- und Majoritätsladungsträger sammelnden Kontakte, die nachfolgend als erste und zweite Kontakte bzw. Emitter- und Basiskontakte bezeichnet werden können, für die Rückseite von Solarzellen bestimmt sind, möglichst geringe Kontaktflächen zur Erzielung hoher Lehrlaufspannungen aufweisen, gut oberflächenpassiviert und einfach herstellbar sind. Hierzu werden allgemein ausgedrückt die entsprechenden Kontakte vorzugsweise durch Schrägaufdampfen im Vakuum unter Ausnutzung eines Abschattungseffektes masken- und justierfrei hergestellt (R. Hezel, Proc. 13th European PVSEC, Nice, S. 115 (1995)). Die Vorderseite sollte vorzugsweise keine Kontakte besitzen, jedoch texturiert sein und eine sehr gute Passivierungsschicht und Antireflexschicht aufweisen. Unter der Antireflexschicht kann das Halbleitersubstrat auch ganzflächig dotiert sein (n⁺ oder p⁺), wodurch eine "floating junction" gebildet wird. Wahlweise kann die Vorderseite auch mit einem zusätzlichen Minoritätsladungsträger sammelnden Kontaktsystem versehen sein.

In den Ausführungsbeispielen sollen rein beispielhaft Strukturen mit ineinandergreifenden MIS- und ohmschen Kontakten diskutiert werden. Ohne die Erfindung zu verlassen, können diese auch durch andere Kontakte ersetzt werden.

Ferner wird bei der Erläuterung der Ausführungsbeispiele von einem p-dotierten Halbleitermaterial ausgegangen, ohne dass dies einschränkend zu verstehen ist. Bei einem anderen Basismaterial müssten zur Erzielung der gewünschten Feldbedingungen ggf. entsprechend andere Leiter bzw. Dotierungen zur Anwendung gelangen.

In Fig. 1 ist rein prinzipiell die Solarzellen 10 mit Frontseite 12 und Rückseite 14 dargestellt. Als Halbleitersubstanz 16 wird ein p-leitendes Material benutzt. Die Rückseite 14 der Solarzelle 10 weist parallel zueinander verlaufende streifen- bzw. stegförmige Erhebungen 18 mit Längsflanken 20, 22 auf, die über einen plateauartig verlaufenden Außenabschnitt 24, der parallel oder im Wesentlichen zur von dem Halbleitersubstrat 16 aufgespannten Ebene verläuft, ineinander übergehen.

Grundsätzlich weist jede Erhebung 18 beabstandet zueinander einen ersten Kontakt oder Emitterkontakt 26 sowie einen zweiten Kontakt oder Basiskontakt 28 auf, wobei sich jeder Kontakt 26, 28 zumindest abschnittsweise entlang der Längsflanken 20, 22 erstreckt und gegebenenfalls bereichsweise entlang des plateauartigen Außenabschnitts 24.

Mit anderen Worten befinden sich die ersten Minoritätsladungsträger sammelnden Kontakte 26 auf einer Flanke der Erhebung 18, die als erste Längsflanke 22 bezeichnet wird, und der zweite die Majoritätsladungsträger sammelnde Kontakt 28 auf der gegenüberliegenden Flanke der selben Erhebung 18, die als zweite Längsflanke 20 bezeichnet wird.

Zwischen den Erhebungen 18 verläuft ein Graben 30, der bodenseitig grundsätzlich parallel zu der von dem Halbleitersubstrat 16 aufgespannten Ebene (Grabenboden 31) oder geneigt zu dieser verlaufen kann, wie an Hand der Fig. 2 bis 5 verdeutlicht wird. Allerdings sollte der Grabenboden zumindest abschnittsweise parallel zu der Ebene verlaufen.

So ist in der Fig. 2 ein Ausschnitt einer Solarzelle wiedergegeben, bei der im Schnitt rechteckförmige Erhebungen 32 mit längsrandseitig abgerundeten Kanten 34, 36 über einen im Schnitt trapezförmigen Graben 38 verbunden sind, der von einer schmalen parallel zu der von dem Halbleitersubstrat 16 aufgespannten Ebene verlaufende (Grabenboden) Bodenfläche 40 sowie geneigt zu dieser verlaufenden Schenkeln 42, 44 begrenzt ist.

Durch die geneigten Schenkel 42, 44 kann im Grabenbereich die Ausbildung einer Textur, wie diese frontseitig bei einer Solarzelle häufig vorhanden ist, weitgehend vermieden werden, da in diesem Bereich nicht die für die Erzeugung von Pyramiden durch eine anisotrop wirkende Texturätze erforderlichen (100) Kristallebenen vorliegen.

Vorteilhaft ist es des Weiteren - wie die Erhebungen 18, 32 verdeutlichen, - wenn deren Längsflanken 20, 22 bzw. 46, 48 senkrecht oder nahezu senkrecht zu der von dem Halbleitersubstrat 16 aufgespannten Ebene verlaufen, da neben einer Stützfunktion erreicht wird, dass eine gegebenenfalls auftretende Textur nur im Bereich der eigentlichen Kontakte 26, 28 vorhanden ist, die in den Ausführungsbeispielen der Fig. 1 bis 5 mit den Bezugszeichen 26, 28 gekennzeichnet sind.

Die Vermeidung einer Textur und damit einer Oberflächenvergrößerung auf der Rückseite 14 der Solarzelle 10 ist vorteilhaft zur Verminderung der für den Wirkungsgrad nachteiligen Ladungsträgerrekombination.

Andere Ausführungsformen von Erhebungen 50, 52, 54 ergeben sich aus den Fig. 3 bis 5. Man erkennt im Schnitt V-, U- oder sägezahnförmige Erhebungen 50, 52 bzw. 54, auf deren jeweiligen Längsflanken die ersten und zweiten Kontakte 26, 28 angeordnet sind.

Unabhängig von der Geometrie ist erkennbar, dass der zwischen den Erhebungen 50 bzw. 52 bzw. 54 verlaufende Grabenbereich grundsätzlich eine Bodenfläche aufweist, die auf die von dem Halbleitersubstrat aufgespannten Ebene ausgerichtet ist, um erwähntermaßen in diesem Bereich eine Textur zu vermeiden, die zu einer unerwünschten Oberflächenvergrößerung und damit Erhöhung der Ladungsträgerrekombination führen würde. Unabhängig hiervon verläuft der Mittenbereich zumindest abschnittsweise entlang der Ebene, gleichwenn Fig. 3 auch eine andere Ausführungsform verdeutlicht, mit der die erfindungsgemäße Lehre realisierbar ist.

Sofern sich auf jeder der Erhebungen ein erster und zweiter Kontakt befindet, ergibt sich eine gleiche Anzahl von Emitter- und Basiskontakten. Allerdings ist es nicht zwingend erforderlich, dass alle Erhebungen beidseitig mit Kontakten belegt sind.

So können beispielsweise mehrere einseitig mit ersten Kontakten 26 versehene Erhebungen nebeneinander liegen und in gewissen Abständen zu diesen erfindungsgemäße Erhebungen mit ersten und zweiten Kontakten 26 bzw. 28 folgen. In diesem Fall wären mehr erste Kontakte 26 als zweite Kontakte 28 vorhanden, wobei letztere einen größeren Abstand als erstere zueinander aufweisen.

Grundsätzlich werden die Kontakte 26, 28 bzw. deren Metallschichten durch Aufdampfen ausgebildet. Die Metallaufdampfung erfolgt dabei allgemein selektiv zuerst von der einen und dann von der anderen Seite der Erhebungen, und zwar unter einem zu der von dem Halbleitersubstrat aufgespannten Ebene flach verlaufendem Winkel, der zwischen 1° und 30° liegen kann. Somit können die Kontakte 26, 28 bzw. deren Metallisierungen die Längsflanken bereichsweise oder ganz abdecken.

Erwähntermaßen ist die Form der Erhebungen in weiten Grenzen variierbar, wobei senkrechte, schräge oder abgerundete Längsflanken bevorzugt zu nennen sind.

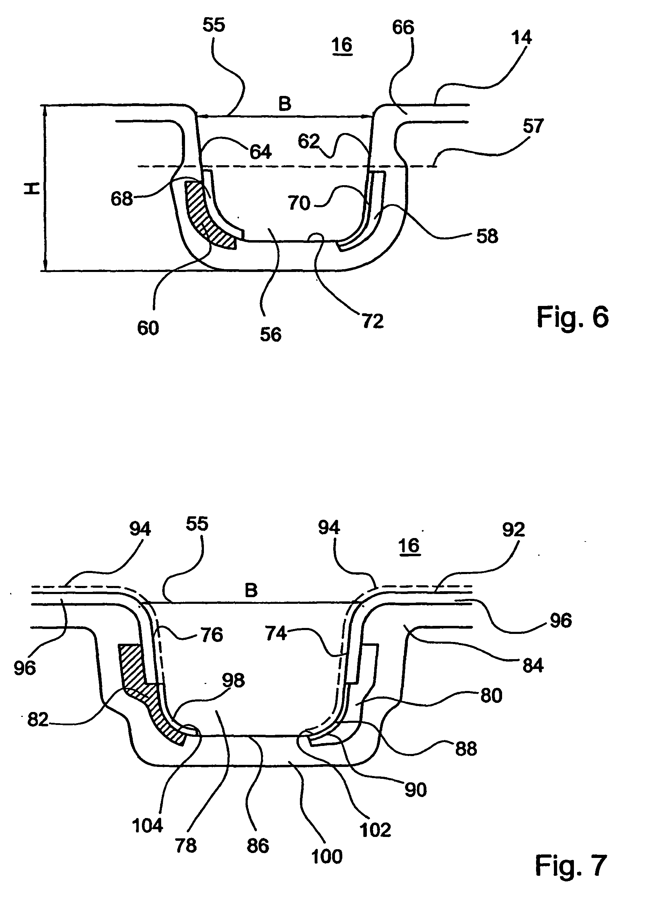

In Fig. 6 ist eine bevorzugte erste Ausführungsform einer auf rückseitiger Erhebung 56 einer Solarzelle angeordneten Kontaktanordnung dargestellt, die erfindungsgemäß einen ersten Minoritätsladungsträger sammelnden und ableitenden Kontakt 58 sowie einen Majoritätsladungsträger sammelnden und ableitenden Kontakt 60 aufweist.

Die ersten und zweiten Kontakte 58, 60 erstrecken sich entlang der ersten und zweiten Längsflanken 62, 64 der Erhebungen, die ihrerseits linien- oder streifenförmig ausgebildet sind und parallel zueinander verlaufen.

Des Weiteren ist aus Fig. 6 erkennbar, dass sich entlang der Rückseite 14 des Halbleiterkörpers 16 eine Schicht 66 in Form einer Passivierungsschicht erstreckt, welche gegebenenfalls auch die ersten und zweiten Kontakte 58, 60 überdecken kann. Alternativ kann die Passivierungsschicht 66 in diesem Bereich ausgespart sein. Bei der ersten Alternative werden zunächst die ersten und zweiten Kontakte 58, 60 auf den Längsflanken 62, 64 ausgebildet und anschließend das Passivierungsmaterial bei Temperaturen abgeschieden, bei denen die Kontakteigenschaften zwischen den ersten und zweiten Kontakten 58, 60 und den ersten und zweiten Längsflanken 62, 64 nicht nachteilig verändert werden.

Soll die Passivierungsschicht 66 bei höheren Temperaturen ausgebildet werden, so müssen - wie nachstehend ausgeführt wird - in dieser Öffnungen zum nachträglichen Anbringen der ersten und zweiten Kontakte 58, 60 ausgebildet werden.

Da die Ladungsträger (Minoritäts- bzw. Majoritätsladungsträger, Elektronen bzw. Löcher) vorwiegend direkt zu den Kontakten 58, 60 diffundieren, sollte im Bereich des zweiten die Majoritätsladungsträger sammelnden Kontaktes 60 eine die Minoritätsladungsträger abstoßende Schicht 68 und damit ein sogenanntes lokales "back surface field" (BSF) erzeugt werden. Im Falle des p-dotierten Halbleitersubstrats handelt es sich bei der Schicht 68 vorzugsweise um eine p⁺-Schicht. Diese kann beispielsweise durch das bekannte Einlegieren von Al (Al-BSF) oder durch Diffusion oder Ionenimplantation ausgebildet werden.

Im Ausführungsbeispiel ist der erste Kontakt 58 als MIS-Kontakt mit einer sehr dünnen Tunnelisolatorscbicht 70 ausgebildet, die z.B. durch einen durch Phosphordiffusion oder Ionenimplantation hergestellten n⁺Metallkontakt (auch in Verbindung mit einer Tunnelisolatorschicht → MI n⁺p) ersetzt werden kann.

Die Herstellung der entsprechenden Kontaktanordnung kann wie folgt vorgenommen werden:

Nach der Passivierung der Vorderseite der Solarzelle durch eine bei optimaler Abscheidetemperatur hergestellten Schicht werden die zweiten oder ohmschen Kontakte 60 auf den seitlichen zweiten Längsflanken 64 der Erhebungen 56 vorzugsweise durch Schrägaufdampfen von Aluminium im Vakuum aufgebracht und sodann auf den plateauartigen Abschnitten 72 der Erhebungen 56 abgeschiedenes Metall sodann durch Ätzen oder eine andere Methode (beispielsweise durch chemisch mechanisches Polieren) beseitigt. Durch eine nachfolgende Temperung in Sauerstoff bei etwa 400 °C - 500°C werden sowohl die ohmschen Kontakte 60 formiert als auch die Tunnelisolator- oder Tunneloxidschicht 70 für die MIS-Kontakte oder ersten Kontakte 58 erzeugt.

Zur Erhöhung der Austrittsarbeitsdifferenz zwischen dem Halbleitersubstrat (z.B. p-Si) und dem Metall (z. B. Al) der MIS-Kontakte 58 kann unmittelbar vor dem Aufbringen des Metalls eine vorzugsweise alkalimetallhaltige Substanz (z. B. CsCl) auf die Tunneloxidschicht vorzugsweise auch durch Schrägaufdampfen im Vakuum aufgebracht werden. Schrägaufdampfen des Metalls (vorzugsweise Aluminium) für die MIS- oder zweiten Kontakte 58 (vorzugsweise Aluminium) und Abätzen des überschüssigen Metalls auf den zwischen den Längsflanken 62, 64 verlaufenden plateauartigen Abschnitten 72 der Erhebungen 56 folgen. Schließlich wird die gesamte Rückseite 14 mit der Passivierungsschicht 66, vorzugsweise Plasma-Siliziumnitrid, abgedeckt. Die Ausbildung einer Inversionsschicht in p-Si sollte - um u. a. Kurzschlüsse zu unterbinden - vermieden werden. Dies kann dadurch erreicht werden, dass auf dem Halbleitersubstrat vorzugsweise eine Passivierungsdoppel- oder -mehrfachschicht aufgebracht bzw. ausgebildet wird, wobei substratseitig eine gegebenenfalls nur einige Atomlagen dicke a-Si:H-Schicht und sodann zumindest eine weitere Schicht wie SiN, Plasma SiN oder SiO₂ verläuft. Selbstverständlich könnte als Passivierung auch allein ein a-Si:H-Schicht ausreichen. Zusätzlich kann als sogenannter Rückseitenspiegel über die gesamte Rückseite 14 ein reflektierendes Metall z.B. Ag oder A1 aufgebracht werden, um zur Erhöhung des Stromes das nicht im Halbleiter absorbierte Licht in diesen zurückzulenken.

Erfindungsgemäß kann sowohl die das lokale elektrische Feld des Majoritätsladungsträgerkontaktes 60 erzeugende Schicht 68 (p⁺ Bereich) als auch ein p-n Minoritätsladungsträgerkontakt (n⁺ Bereich) anstelle des erläuterten MIS Kontaktes 58 in Fig. 6 durch die Methode der Schrägionenimplantation erzeugt werden. Hierbei wird, wie im Falle der Schrägaufdampfung des Metalls im Vakuum für die Kontakte 58, 60, die durch die Erhebungen bewirkte Selbstabschattung ausgenutzt, um unter einem sehr flachen Winkel zur Halbleitemberfläche (= von dem Halbleitersubstrat 16 aufgespannte Ebene, die parallel zur Frontfläche 12 der Solarzelle verläuft) z.B. Bor- oder Phosphorionen maskierungs- und justierfrei bereichsweise oder im gesamten Flankenbereich zu implantieren. Der Winkel liegt vorzugsweise im Bereich zwischen 1° bis 30°.

Nach einem Ausheil-Temperaturprozess kann sodann die lokale Aufbringung des Metalls, vorzugsweise durch Schrägaufdampfen im Vakuum, ebenfalls justier- und maskenfrei erfolgen.

Durch eine sehr dichte, nahezu parallele Anordnung von Halbleitersubstraten in einer Implantationsanlage wird die Wirtschaftlichkeit der herkömmlichen Ionenimplantation drastisch erhöht (vgl. Schrägaufdampfmethode) (R. Hezel and A. Metz, Renewable Energy 14, p. 83-88 (1998)).

Der Fig. 7 ist ein Ausschnitt einer weiteren hervorzuhebenden Ausführungsform einer Solarzelle 10 zu entnehmen, bei der sich auf ersten und zweiten Längsflanken 74, 76 von rückseitigen Erhebungen 78 eines Halbleitersubstratkörpers 16 erste und zweite Kontakte 80, 82 erstrecken, die sich teilweise auf Material des Halbleitersubstrats 16 und teilweise auf einer ersten Passivierungsschicht 96 erstrecken, die rückseitig auf dem Halbleitersubstrat 16 verläuft.

Entsprechend der erfindungs gemäßen Lehre verlaufen die ersten und zweiten Kontakte 80, 82 auf den gegenüberliegenden ersten und zweiten Längsflanken 74, 76 der Erhebungen 78 und sind im Bereich deren plateauartigen Außenabschnitts 86 zueinander beabstandet. Der plateauartige Außenabschnitt 86 oder Bereich entspricht den in den Fig. 1 und 6 mit dem Bezugszeichen 24 versehenen Außenabschnitten der Erhebungen 18 bzw. 56. Ferner verlaufen die ersten und zweiten Kontakte 80, 82 beabstandet zum Grabenboden, im Ausführungsbeispiel erheblich beabstandet zum Rand des Grabenbodens.

Für den ersten Minoritätsladungsträger sammelnden Kontakt 80 wurde entsprechend der Fig. 6 eine Metall-Isolator-Halbleiter(MIS)-Anordnung mit einem dünnen Tunneloxid vorzugsweise in Form einer alkalimetallhaltigen Schicht 88 zwischen außenliegender Metallschicht 90 und dem Halbleitersubstrat gewählt.

Unterhalb des so gebildeten MIS-Kontaktes 80 und auf übriger rückseitiger Oberfläche 92 des Halbleitersubstrats 16 erstreckt sich eine Minoritätsladungsträgerableitschicht 94, die auch als Emitterschicht bezeichnet werden kann.

Im Falle des p-leitenden Halbleiters als Halbleitersubstrat 16 kann es sich bei der Emitterschicht 94 um eine n-leitende Inversionsschicht handeln, die durch positive Ladungen in der Passivierungsschicht 96 oder eine diffundierte oder ionenimplantierte n⁺-Schicht gebildet wird. Die Passivierungsschicht 96 verläuft dabei entlang der Oberfläche 92 des Halbleitersubstrats 16 und ist im Bereich der ersten und zweiten Kontakte 80, 82 teilweise unterbrochen.

Die Emitterschicht 94 sollte potentialmäßig zu dem zweiten Kontakt 82 getrennt sein. Vorzugsweise endet die Emitterschicht 94 beabstandet zu dem zweiten Kontakt 82, um zu verhindern, dass Minoritätsladungsträger an dem zweiten Kontakt rekombinieren und somit ein Kurzschluss zwischen dem ersten und zweiten Kontakt 80, 82 erfolgt.

Zur Trennung der ersten und zweiten Kontakte 80, 82 - bzw. Emitter- und Basiskontakte - ist es grundsätzlich von Vorteil, die Emitterschicht 94 oder n-leitende Schicht in unmittelbarer Nähe vor dem zweiten Kontakt 82 unter der Passivierungsschicht 96 enden zu lassen und/oder eine Sperrschicht zwischen der n-leitenden Schicht 94 und dem zweiten Kontakt 82 einzubringen.

Alternativ kann auch ein lokales back surface field (BSF) 98, wie dies im Zusammenhang mit der Fig. 6 erläutert worden ist, entlang substratseitiger Seite des zweiten Kontaktes 82 und seitlich beidseitig über den von dem Metall des zweiten Kontaktes bedeckten Bereich des Halbleitersubstrats 16 gebildet werden. Hierdurch entsteht eine Potentialbarriere zwischen der n-leitenden Schicht oder Emitterschicht 94 und der p-leitenden BSF-Schicht 98, die ein Abfließen der Minoritätsladungsträger oder Elektronen zum Majoritätsladungsträgerkontakt 82 weitgehend verhindert.

Im Falle einer Inversionsschicht als Emitterschicht 94 ist eine lokale BSF-Schicht 98 ebenfalls von Vorteil, gleichwenn auch ohne das Ausbilden der BSF-Schicht 98 eine Potentialbarriere am zweiten Kontakt 82 vorliegt, die weitgehend das Abfließen der Minoritatsladungsträger (Elektronen) in den Majoritätsladungsträgerkontakt 82 unterbindet. (R. Hezel and K. Jaeger, J. Electrochem. Soc. 136, 518 (1989)).

Die Emitterschicht kann vorzugsweise durch Phosphordiffusion und das lokale Rückseitenfeld vorzugsweise durch Legierungen von Aluminium ausgebildet werden, und zwar gemeinsam in einem einzigen thermischen Verfahrensschritt. Hierdurch ergibt sich eine verfahrenstechnische Vereinfachung.

Schließlich befindet sich über der gesamten Rückseite 14 eine zweite Passivierungsschicht 100, über die optional noch eine metallische Schicht als Lichtreflektor (Back Surface Reflector) abgeschieden werden kann. Diese Passivierungsschicht 100 sollte grundsätzlich das Entstehen einer Inversionsschicht verhindern, da anderenfalls die Gefahr bestünde, dass zwischen dem jeweiligen ersten und zweiten Kontakt 80, 82 ein Kurzschluss entsteht.

Ganz allgemein ist darauf hinzuweisen, dass die Passivierungsschicht unmittelbar oder mittelbar - z.B. durch Ausbilden einer Inversionsschicht- sicherstellen sollten, dass ein Ladungsträgertransport zwischen dem ersten und dem zweiten Kontakt unterbunden oder im Wesentlichen unterbunden wird.

Bei der in Fig 7 dargestellten Ausführungsform gelangen die durch das Licht erzeugten Ladungsträger über eine sich nahezu über die gesamte Rückseite 14 der Solarzelle erstreckende hochdotierte n⁺ Schicht oder eine durch positive Ladungen in der Passivierungsschicht 96 im Halbleiter bzw. Halbleitersubstrat 16 erzeugte n-leitende Inversionsschicht 94 zu den ersten Kontakten 80. Als Passivierungsschicht 96, durch die gleichzeitig im Halbleiter die Inversionsschicht 94 erzeugt wird, soll bei p-Halbleitern vorzugsweise Siliziumnitrid, im Plasma abgeschieden und positive Ladungen enthaltend, zur Anwendung kommen. Die Inversionsschicht 94 - beispielsweise im p-Silizium - wird teils durch natürliche an der Isolator-Halbleitergrenzfläche auftretende positive Ladungen influenziert, kann aber in ihrer Leitfähigkeit noch wesentlich verbessert werden durch Erhöhung der positiven Ladungsdichte, vorzugsweise durch Einbau alkalimetallhaltiger Substanzen in das Siliziumnitrid (Passivierungsschicht 96) in geringem Abstand (1 - 10 nm) von der Halbleiteroberfläche 92. Zwischen der Siliziumnitridschicht und dem Halbleiter kann auch eine andere dünne Isolatorschicht (z.B. SiOx einer Dicke von 1 nm - 10 nm) eingebaut werden.

Zuvor beschriebene Anordnung bildet eine rückseitig ganzflächig sammelnde Solarzelle. Im Gegensatz zu der der Fig. 6 zu entnehmenden Lehre werden durch die sich nahezu über die gesamte Rückseite 14 erstreckende Inversionsschicht 94 oder n⁺ Schicht mit anschließender Raumladungszone die Ladungsträgerpaare (Minoritäts- und Majoritätsladungsträger) getrennt, und zwar weit bevor diese zu den Kontakten 80, 82 gelangen. Die Löcher (Majoritätsladungsträger) diffundieren in den erhabenen Bereichen (Erhebungen 78) hin zu den seitlich angeordneten zweiten oder ohmschen Kontakten 82. Die Elektronen (Minoritätsladungsträger) hingegen werden, falls die Breite der Erhebungen 78 kleiner als die doppelte Diffusionslänge der Elektronen ist, sämtlich am Eingang der Erhebungen 78 von der beidseitig verlaufenden Emitterschicht bzw. Inversions- bzw. n⁺-Schicht 94 gesammelt, so dass erstere nicht zum Majoritätsladungsträgerkontakt 82 gelangen und dort rekombinieren können. Der Majoritätsladungsträgerkontakt 82 ist demnach, im Gegensatz zu allen bekannten Solarzellen, nahezu ausschließlich Majoritätsladungsträgern ausgesetzt.

Die erfindungsgemäße Anordnung der auf Erhebungen einander gegenüberliegenden und mit einer leitfähigen Schicht 94 (n⁺, Inversionsschicht etc.) umgebenen Kontakte 80, 82 stellt damit auf einfache geometrische Weise eine höchsteffiziente Trennung der Ladungsträger auch im Bereich der Kontakte 80, 82 sicher.

Es können zusätzlich - wie in den Fig. 6 und 7 für den Majoritätsladungsträgerkontaktbereich eingezeichnet - lokal diffundierte, legierte oder ionenimplantierte Gebiete (n⁺) für den Minoritätsladungsträgerkontakt 80 angebracht werden.

In Bezug auf die Kontaktherstellung werden nach der Fig. 7 die ersten und zweiten Kontakte 80, 82 bereichsweise auf zuvor mit Passivierungsmaterial abgedeckten und sodann von diesen freigelegten Abschnitten der Erhebungen 78 unmittelbar oder auf einer Isolatorschicht angeordnet Hierzu wird zunächst die gesamte Halbleitersubstrat fläche 92 mit einer auf geringste Oberflächenrekombinationsgeschwindigkeit optimierte und gegebenenfalls zur Erhöhung der positiven Grenzflächenladungen vorzugsweise mit einer alkalimetallhaltigen Substanz versehenen Passivierungsschicht 96 abgedeckt. Sodann wird vorzugsweise durch chemisch mechanisches Polieren (CMP) die Passivierungsschicht 96 und bereichsweise das Halbleitermaterial im oberen Flankenbereich (Längsränder 102 und 104 der ersten und zweiten Längsflanken 74, 76) und auf der Oberfläche des plateauartigen Außenabschnitts 86 der Erhebungen 78 abgetragen, wobei es zur Ausbildung abgerundeter Kanten kommen kann. Anschließend wird vorzugsweise durch Schrägaufdampfen im Vakuum Metall zur Bildung der ohmschen Kontakte 82 auf jeweils einer Seite der Erhebungen 78 (zweite Längsflanke 76) abgeschieden. Danach erfolgt eine Wärmebehandlung (Temperierung) bei 400 °C - 500°C zur Formierung der ohmschen Kontakte 82, wobei durch Zugabe von Sauerstoff gleichzeitig Tunneloxid (Schicht 88) auf der vorher von der Passivierungsschicht 96 freigelegten Halbleiteroberfläche 92 auf der gegenüberliegenden Seite (erste Längsflanke 74) der Erhebungen 78 gebildet wird. Sodann wird auf das Tunneloxid eine dünne Schicht eines Materials mit niedriger Elektronenaustrittsarbeit, vorzugsweise Alkalimetalle oder deren Verbindungen, aufgebracht, um die Austrittsarbeitsdifferenz zwischen dem Metall (Schicht 90) und Halbleiter (Substrat 16) zu erhöhen. Der erste als MIS-Kontakt ausgebildete Kontakt 80 wird komplettiert durch Schrägaufdampfen von Metall (Schicht 90) auf den oberen Teil der ersten Längsflanke 74, wobei die Schicht 90 im unteren Bereich der Längsflanken 74 auch bereichsweise auf der Passivierungsschicht 96 verläuft. Im oberen Teil, also längskantenseitigem Bereich kann sich das Metall und damit der MIS Kontakt 80 noch über die Rundung (Längskante 102) bereichsweise zu dem die Längsflanken 74, 76 verbindenden Außenabschnitt 86 der Erhebungen 78 erstrecken.

Eine exakte Trennung der beiden Kontakte 80, 82 in dem plateauartigen Abschnitt 86 der Erhebungen 78 und damit die Vermeidung eines Kurzschlusses der Solarzelle ist von ausschlaggebender Bedeutung. Abschließend wird die gesamte Rückseite abermals mit einer Passivierungsschicht (Schicht 100) überzogen, um freigelegte Halbleitersubstratflächen (Abschnitt 86) auf den Erhebungen 78 zwischen den ersten und zweiten Kontakten 80, 82 und zur Verhinderung von Kurzschlüssen abzudecken. Die Ausbildung einer Inversionsschicht im Halbleiter sollte dabei vermieden werden. Zusätzlich ist die Aufbringung eines Rückseitenspiegels möglich.

Von besonderer Bedeutung ist auch die Tatsache, dass das beim Schrägaufdampfen auch auf dem plateauartigen Abschnitt 86 der Erhebungen 78 abgeschiedene, die ersten und zweiten Kontakte 80, 82 verbindende und damit die Zelle kurzschließende Metall auf einfache Weise entfernt werden kann. Ein entscheidendes Merkmal der Schrägaufdampfung ist es nämlich, dass das unter einem flachen Winkel auf die Oberfläche auftreffende Metall zum einen wesentlich dünner ist als das auf die Längsflanken 74, 76 für die Kontakte 80, 82 abgeschiedene Metall, zum anderen wächst das Metall aufgrund seiner Stengelstruktur sehr locker auf, so dass dieses schon durch einen kurzen Ätzvorgang beseitigt werden kann. Dadurch wird die Dicke des Metalls (Metallfinger) auf den Längsflanken 74, 76 nur unwesentlich verringert.

Alternativ kann das beim Schrägaufdampfen auf den Abschnitten 86 der Erhebungen 78 abgeschiedene Metall auf mechanische Weise oder durch chemisch-mechanisches Polieren (CMP) entfernt werden. Mit dieser selektiven Methode wird auch die beispielsweise während der Diffusion auf den plateauartigen Abschnitten 86 der Erhebungen 78 entstehende n⁺-Schicht, welche die beiden Kontakte 80, 82 verbindet, beseitigt. Damit ist eine sehr gute Trennung zwischen den Emitter- und Basiskontakten, also den ersten und zweiten Kontakten 80, 82 gewährleistet. Durch das Entfernen der leitenden Schicht wird sichergestellt, dass zwischen dem ersten und zweiten Kontakt ein Kurzschluss ausgeschlossen ist.

Ein eigenerfinderischer Vorschlag ist in den Maßnahmen zu sehen, mit Hilfe des chemisch-mechanischen Polierens (CMP) die Passivierungsschicht 96 und möglichst wenig Halbleitermaterial bereichsweise von den Längsflanken 74, 76 der Erhebungen 78 zu entfernen, um dort zumindest auf einer, möglichst aber auf beiden Seiten der Erhebungen 78 die metallischen Kontakte 80, 82 vorzugsweise durch Schrägaufdampfen im Vakuum anbringen zu können. Diese lokale Entfernung im oberen Teil des Flankenbereiches erfolgt erfindungsgemäße dadurch, dass die mit die Erhebungen 78 begrenzenden Gräben versehenen Halbleitersubstrate 16 nicht auf dem Polierteller rotieren, wie es bei CMP üblich ist und auch z.B. in der DE 41 43 083 A1 zur Entfernung der Passivienmgsschicht nur von der Oberseite von Erhebungen ausgeführt wurde, sondern in einer bestimmten Position festgehalten werden. Zusätzlich erfolgt nach der erfindungsgemäßen Lehre die Positionierung derart, dass die Gräben nahezu parallel, also unter einem relativ kleinen Winkel γ zur Bewegungsrichtung des Polierelements wie rotierendem Poliertuchs zu liegen kommen, wodurch ein ungehindertes Zuströmen des Poliermittels zu den Flanken ermöglicht wird. Es erfolgt ein sogenanntes Schrägpolieren. Hierdurch wirkt auf die jeweilige Längsflanke der Erhebungen eine relativ hohe Polierkraft, so dass die seitliche Abtragungsgeschwindigkeit von Passivienmgsschicht 96 und Halbleitermaterial und damit die Kontaktöffnung im Verhältnis zur Abtragungsgeschwindigkeit auf der Oberfläche (Abschnitt 86) der Erhebungen 78 optimiert wird. Ein Winkelbereich von 1° bis 30° zwischen der Polierrichtung und den Gräben bzw. Erhebungen 78 dürfte besonders zu empfehlen sein. Sowohl eine Polierrichtung mit rotierendem Element wie Scheibe als auch eine lineare Polieranordnung, also translatorische Hin- und Herbewegung oder Linearbewegung, können eingesetzt werden. In allen Fällen kommt es zu einer Verrundung der Längskanten 102, 104 der Erhebungen 78.

Erfindungsgemäß kann auch das lokale Entfernen der Passivierungsschicht im Kontaktbereich vermieden werden, indem man vor Abscheidung der Passivierungsschicht im späteren Kontaktbereich im oberen Teil der Flanken und - falls nicht zu umgehen - auch auf den Erhebungen eine Schutzschicht z.B. durch Rolldruck oder Tauchverfahren oder durch Schrägaufdampfen oder dergleichen aufbringt. Damit wird in diesen Bereichen keine Passivierungsschicht auf dem Halbleiter abgeschieden, die Schutzschicht wird samt darüberliegender Passivierungsschicht entfernt und das Kontaktmetall vorzugsweise durch Schrägaufdampfen im Vakuum aufgebracht.

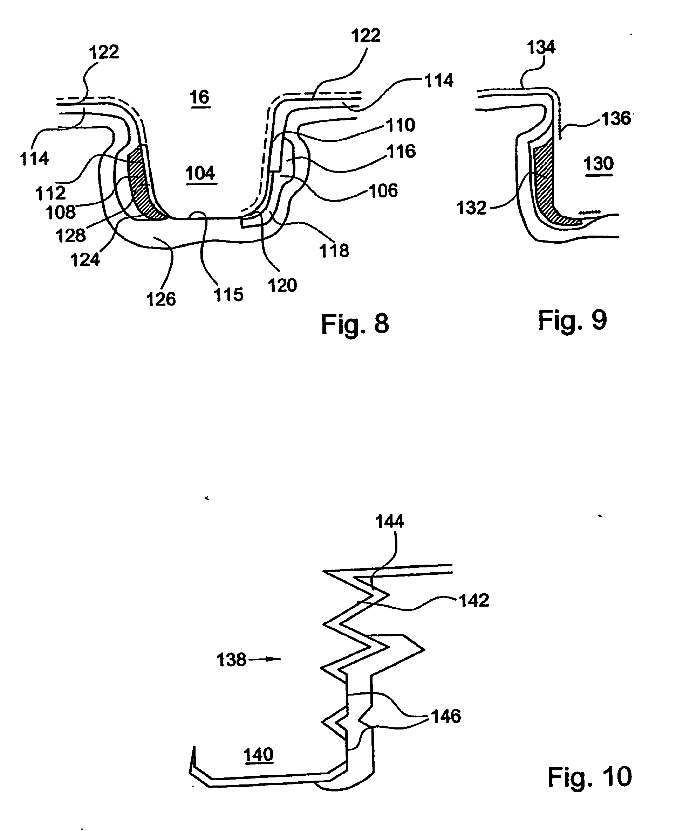

Der Fig. 8 sind weitere selbständig Schutz genießende Merkmale der erfindungsgemäßen Lehre zu entnehmen soweit der rückseitige Kontaktbereich betroffen ist. So ist in Fig. 8 ein Ausschnitt einer Solarzelle im Bereich einer Erhebung 104 dargestellt, die von der Rückseite einer Solarzelle ausgeht. Dabei weist die Solarzelle - wie bei den Ausführungsbeispielen der Fig. 1 bis 7 - eine Vielzahl der parallel zueinander verlaufenden streifen- bzw. stegförmigen Erhebungen 104 auf, die demzufolge von Gräben begrenzt sind, die im Zusammenhang mit den Fig. 1 bis 5 erläutert worden sind. Dies gilt insbesondere auch in Bezug auf das gezielte Ausbilden bzw. Unterdrücken einer Textur. Dabei weisen die Gräben bevorzugterweise parallel zur von dem Halbleitersubstrat aufgespannten Ebene verlaufende Grabenböden auf, die von den elektrisch leitenden Kontakten unbedeckt sind.

Bei der Kontaktanordnung nach der Fig. 8 sind ebenfalls erste und zweite Kontakte 106, 108 vorgesehen, die auf ersten und zweiten Längsflanken 110, 112 des Halbleitersubstrats 16 der Solarzelle verlaufen. Dabei gehen die Kontakte 106, 108 von der selben Erhebung 104 aus und sind im Bereich deren freier plateauartig verlaufender Oberfläche 114, also im Außenabschnitt der Erhebung 104 zueinander beabstandet.

Abweichend vom Ausfürungsbeispiel der Fig. 7 erstreckt sich unterhalb des zweiten oder Majoritätsladungsträgerkontaktes bzw. Basiskontaktes 108 eine Passivienmgsschicht 114 nicht. Vielmehr ist der zweite Kontakt 108 unmittelbar auf dem Halbleitersubstrat 16, und zwar auf dessen zweiter Längsflanke 112 angeordnet. Demgegenüber ist der erste oder Minoritätsladungsträgerkontakt 106 in dem der Basis der Erhebung 104 naheliegenden Bereich 116 auf der Passivierungsschicht 114 angeordnet, wohingegen verbleibender längsrandseitiger Bereich 118 unmittelbar auf dem Halbleitersubstrat bzw. auf einer Isolatorschicht 120 angeordnet ist, wie dies an Hand der Fig. 4 erläutert wurde.

Damit der erste Kontakt 106 nur bereichsweise entlang der Passivierungsschicht 114 verläuft, wird die zunächst auf der in der Figur dargestellten rechten Längsflanke 110 verlaufende Passivierungsschicht 114 bereichsweise entfernt. Sodann wird der erste Kontakt 106 ausgebildet, der erwähntermaßen teils auf dem Halbleitermaterial, teils auf der Passivierungsschicht 114 verläuft. Dabei wird im Falle eines MIS-Kontaktes als ersten Kontakt 106 auf den Halbleiter die Schicht 120 z. B. in Form einer Tunneloxidschicht ausgebildet.

Entsprechend des das Ausführungsbeispiel der Fig. 7 insbesondere kennzeichnenden Merkmals erstreckt sich des Weiteren entlang der Halbleitersubstratoberfläche 122 eine Emitterschicht 102 wie n-leitende Inversionsschicht oder eine durch vorzugsweise Diffusion oder Ionenimplantation erzeugte n⁺-Schicht. Zusätzlich kann eine lokale BSF-Schicht 124 unterhalb des zweiten Kontaktes 108 angebracht werden. Schließlich kann die gesamte Rückseite 14 der Solarzelle mit einer zweiten Passivierungsschicht 126 abgedeckt werden, die sich folglich auch über die ersten und zweiten Kontakte 106, 108 erstreckt.

Die entsprechende erfindungsgemäße Kontaktanordnung wird wie folgt hergestellt:

Nach der Ausbildung der Erhebungen 104 auf dem Halbleitersubstrat 16 wird auf den zweiten Längsflanken 112 der Erhebungen 104 insbesondere durch Schrägaufdampfung im Vakuum zunächst der zweite Kontakt 108 aufgebracht. Wahlweise kann durch eine Al-Legierung oder zuvor durch eine Bor-Implantation eine BSF-Schicht 128 ausgebildet werden, deren flächige Erstreckung derart gewählt ist, dass sich die Längsränder des zweiten Kontakt 108 auf der BSF-Schicht 128 erstrecken. Sodann wird über die gesamte Rückseite die Passivierungsschicht 114 vorzugsweise in Form von Siliziumnitrid abgeschieden, wobei vorzugsweise zuvor auf der Halbleiteroberfläche eine dünne Isolatorschicht einer Stärke zwischen 1 nm und 10 nm erzeugt wird, die mit einer positive Ladungen erzeugenden Substanz, vorzugsweise ein Alkalimetall oder Verbindungen dieses belegt wird. Hierdurch wird die gewünschte sich über die gesamte Halbleiteroberfläche erstreckende Emitterschicht (z.B. n-leitende Inversionsschicht oder n⁺-Schicht) ausgebildet, entlang der die Minoritätsladungsträger (Elektronen) zu den ersten Kontakten 106 gelangen. Zum Anbringen der Minoritätsladungsträgerkontakte 106 wird vorzugsweise durch Schrägpolieren die Passivierungsschicht 114 bereichsweise entfernt. Sodann schließt sich eine Temperaturbehandlung mit Sauerstoffzugabe bei 400 °C bis 500 °C an, durch die einerseits die zweiten Kontakte 108 oder ohmschen Kontakte formiert werden und andererseits die Tunnelomidschichten 120 wachsen, die für den im Ausführungsbeispiel als MIS-Kontakt ausgebildeten ersten Kontakt 106 notwendig sind. Sodann wird vorzugsweise ebenfalls durch Schrägaufdampfung das für die ersten Kontakte 106 erforderliche Metall auf den freigelegten Bereichen der ersten Längsflanken 110, teils auf der Passivierungsschicht 114 aufgebracht. Schließlich wird die gesamte Rückseite mit der zweiten Passivierungsschicht 126 abgedeckt, wodurch auch der unbelegte Bereich des plateauartigen Abschnitts 115 oder Außenabschnittes der Erhebung 104 passiviert wird, wodurch wiederum die gewünschte elektrische Trennung zwischen den ersten und zweiten Kontakten 106, 108 gewährleistet ist. Als Passivierungsmaterialien kommen ganz allgemein Siliziumoxid, Siliziumnitrid, Aluminiumoxid, amorphes Si: H etc. in Frage. Vorzugsweise wird zur Vermeidung der Ausbildung einer Inversionsschicht im plateauartigen Bereich 115 des p-Halbleitersubstrats ein Mehrschichtsystem aus z. B. substratseitig verlaufender a-Si:H Schicht und über dieser verlaufender Schicht wie Plasma-SiN, SiN oder SiO₂ gewählt.

Um einen Kurzschluss zu vermeiden, ist es von Vorteil, wenn sich die Emitterschicht (Inversionsschicht oder n⁺-Schicht) 122, sofern im Bereich des zweiten Kontaktes 108 die ein lokales Rückseitenfeld erzeugende Schicht 124 fehlt, nicht direkt bis zu dem zweiten Kontakt 108 erstreckt. Dies ist insbesondere bei Vorliegen einer n⁺-Schicht als Emitterschicht 122 von Bedeutung.

Bezüglich des ersten, also Minoritätsladungsträger sammelnden Kontakts 106 ist vorgesehen, dass sich entweder die Emitterschicht 120 unter dem Kontakt 106 fortsetzt oder es wird ein z. B. phosphordiffundierter oder implantierter n⁺-Bereich unter dem Kontakt 106 eingebracht.

Somit kann an eine Inversionsschicht als Emitterschicht im Nichtkontaktbereich sowohl eine Inversionsschicht als auch eine lokale n⁺-Schicht an den ersten Kontakt 106 angrenzen (n⁺p Kontakt). Selbstverständlich ist auch eine durchgehende n⁺-Schicht, die bei dem ersten Kontakt durch die Tunneloxidschicht 120 überdeckt sein sollte, möglich (MI n⁺p).

Zu den Fig. 6 bis 8 ist ergänzend Folgendes auszuführen. In den Fig. 7 und 8 kann die Emitterschicht 94, 122 auch im Plateau-Bereich 86, 115 vorhanden sein. Die Emitterschicht 94, 122 muss zum Kontakt 82, 108 beabstandet sein, um einen Kurzschluss zu vermeiden, oder durch das Rückseitenfeld 98 blockiert werden.

In Fig. 6 kann sich auch über die gesamte Rückseite 14 einschließlich den Plateaubereich 72 - mit Ausnahme des Rückseitenfeldbereichs 68 des Kontaktes 60 - eine hochdotierte n⁺-Schicht oder n-leitende Inversionsschicht erstrecken, -ähnlich den Fig. 7 und 8 -, wodurch eine Ladungsträgersammlung im gesamten Rückseitenbereich erfolgt.

Der Fig. 9 ist ein Ausführungsbeispiel einer Erhebung 130 auf der Rückseite eines Halbleitersubstrats zu entnehmen, bei dem sich unterhalb eines zweiten, Majoritätsladungsträger sammelnden Kontaktes 132 ein lokaler BSF-Bereich nicht befindet. Um jedoch ein Abfließen der Minoritätsladungsträger aus einer sich entlang der Halbleitersubstratfläche erstreckenden Emitterschicht wie Inversionsschicht 134 in den zweiten Kontakt 132 zu unterbinden, kann zwischen dem zweiten Kontakt 132 und der Emitterschicht 134 eine Akkumulationsschicht 136 erzeugt werden, die eine Potentialbarriere als "Channelstopper" bildet.

Sofern als Metall für den zweiten Kontakt 132 Aluminium Verwendung findet, kann die Potentialbarriere durch Oxidation des Aluminiums zu Aluminiumoxid gebildet werden, das an seiner Grenze zum Halberleitersubstrat wie Silizium negative Ladungen enthält, die im Halbleitersubstrat zur Ausbildung der Akkumulationsschicht 136 führt. Alternativ kann auch eine negative Ladung enthaltende Schicht wie z.B. Aluminiumoxid über den zweiten Kontakt 132 abgeschieden werden (R. Hezel and K. Jaeger, J. Electrochem. Soc. 136, 518 (1989)).

Eine Unterbrechung der n+-Schicht, insbesondere der Inversionsschicht 94, 122, 134 in den Fig. 7 bis 9 vor dem zweiten Kontakt 82, 108, 132 kann erfindungsgemäß durch Schrägbeshahlung der Anordnung mit energiereicher Strahlung, z.B. hartes UV-Licht oder ähnliches, über den Metallbereich hinaus erreicht werden. Dabei wird erneut der Effekt der Selbstabschattung der Erhebungen ausgenutzt. Der Einstrahlungswinkel muss dabei etwas größer sein als der beim Schrägaufdampfen des Kontaktmetalls gewählte Aufdampfwinkel.

Nach einem weiteren Vorschlag der Erfindung kann die Rückseite einer Solarzelle, insbesondere Längsflanken 138 von Erhebungen, auf denen erfindungsgemäße Kontaktanordnungen ausgebildet werden, durch Behandlung mit einer anisotrop wirkenden Textur-Ätze pyramidenförmige Erhebungen 142 aufweisen, die ihrerseits mit einer Passivierungsschicht 144 abgedeckt sind. Durch beispielsweise das zuvor erwähnte chemisch-mechanische Polieren (CMP) können sodann die Längsflanken 138 an ihren Oberflächen mit der Folge behandelt werden, dass die pyramidenförmigen Vorsprünge 142 in ihren Spitzen abgetragen werden, so dass sich flächige Bereiche 146 ergeben, die bei pyramidenförmigen Vorsprüngen 142 im Wesentlichen eine quadratische Geometrie aufweisen. In diesen Flächen 146 ist ein Halbleitersubstrat freigelegt, so dass in Folge dessen die Passivierungsschicht 144 unterbrochen ist. Anschließend werden die ersten und zweiten Kontakte ausgebildet.

Wie der Prinzipdarstellung gemäß Fig. 10 zu entnehmen ist, werden die Vorsprünge 142 nahezu vollständig abgetragen. Es verbleiben jedoch Gräben zwischen den abgetragenen Vorsprünge 142, die von der Passivierungsschicht 144 abgedeckt sind. Durch diese Maßnahmen ist es möglich, anstelle eines durchgehenden linienförmigen Kontaktes eine Aneinanderreihung von Punktkontakten, die die gewünschten ersten und zweiten Kontakte bilden, zu erhalten, wodurch einerseits eine kleinere Kontaktfläche und andererseits eine Verringerung des negativen Einflusses durch den sogenannten "Crowding-Effect" erzielt wird, sofern es sich bei dem ersten Minoritätsladungsträger sammelnden Kontakt um einen MIS-Kontakt handelt. Dies bedeutet, dass der Umfang der MIS-Kontakte im Verhältnis zu ihrer Gesamtfläche größer wird, wodurch die Minoritätsladungsträger ohne wesentliche Erhöhung des Widerstandes in die Kontakte fließen können.

Wie zuvor erläutert wurde kann vorteilhafterweise die Rückseitenstruktur auch derart gestaltet werden, dass die Texturierung, d. h. die Erzeugung von insbesondere Pyramiden nur im Kontaktbereich an den Längsflanken erfolgt, während im Grabenbereich eine glatte Halbleiteroberfläche vorliegt. Dadurch wird die durch die Textur erfolgende Vergrößerung der Oberfläche und die damit einhergehende Erhöhung der Ladungsträgerrekombination vermieden. Eine derartige Struktur kann, wie dies an Hand der Fig. 2 verdeutlicht wird, so erfolgen, dass die Längsflanken zumindest bereichsweise vertikal oder nahezu vertikal zur von dem Halbleitersubstrat aufgespannten Ebene ausgebildet und die zwischen den Flanken verlaufenden Gräben unter einem gewünschten Winkel zur der von dem Halbleitersubstrat aufgespannten Ebene verlaufen, so dass auf Grund der von der (100) Richtung abweichenden Kristallorientierung eine Texturierung unterbleibt.

Zu den erfindungsgemäß ausgebildeten Kontaktanordnungen ist allgemein folgendes anzumerken:

Entgegen den bisherigen Anordnungen können die zweiten Kontakte beliebig kleine Abstände zueinander besitzen, da eine erhöhte Rekombination an diesen Kontakten infolge der Abschirmung nicht eintreten kann. Der maximale Abstand der zweiten Majoritätsladungsträger sammelnden oder ohmschen Kontakte ist durch den Widerstand des Halbleitergrundkörpers gegeben, sofern die Majoritätsladungsträger (Löcher) von vorne kommend zu weite Wege schräg zu den Kontakten zurücklegen müssen. In den meisten Fällen der erfindungsgemäßen Anordnung tritt dieser Fall nicht auf, da der Abstand der zweiten Kontakte durch den der ersten Minoritätsträger sammelnden Kontakte vorgegeben ist und dieser wegen der begrenzten Leitfähigkeit der Emitterschicht (Inversionsschicht bzw. der n⁺-Schicht) wesentlich geringer sein muß als der normalerweise zwischen ohmschen Kontakten vorliegende. Die Abstände der ersten Kontakte voneinander und damit auch der zweiten Kontakte voneinander bewegen sich zwischen 50 µm und 3 mm.

Die Breite B der Erhebungen und damit die Abstände von ersten und zweiten Kontakten zueinander können sich je nach Diffusionslänge der Minoritätsladungsträger von 5 µm bis über 2 mm bewegen, sollten jedoch, sofern eine n⁺-Schicht oder eine Inversionsschicht entlang der Halbleiterfläche verläuft, kleiner sein als die doppelte Diffusionslänge der Minoritätsladungsträger. Die Breite der Kontaktfinger sollte vorzugsweise im Bereich von 1 µm und 100 µm liegen. Im Regelfall wird der Kontakt nur einen Teil der Flanke der Erhebungen bedecken, die sich in ihrer jeweiligen Höhe H zwischen 20 µm und 150 µm bewegen.

Die Dicke D des Halbleitersubstrates im Grabenbereich (ohne Erhebungen) sollte wesentlich kleiner sein als die Diffusionslänge der Minoritätsladungsträger - in der Regel zwischen 30 µm und 300 µm. Die jeweilige Dicke des Halbleitersubstrats kann durch die Tiefe der Gräben eingestellt werden und somit im Solarzellenprozess auf das Material abgestimmt werden.

Die erfindungsgemäße Rückseitenkonfiguration eignet sich auch zur Nutzung von rückseitig auffallendem Licht, da die Abschattung durch die Kontakte infolge ihrer Anordnung auf den steilen Flanken sehr gering ist und die Ladungsträger sehr nahe an den Kontakten erzeugt werden. Liegt ein Halbleitermaterial mit sehr kleinen Diffusionslängen wie z.B. polykristallines Silizium vor, so kann zusätzlich auf die Vorderseite der Solarzelle ein Kontaktsystem zur Sammlung von Minoritätsladungsträgern aufgebracht werden, welches mit den entsprechenden rückseitigen Kontakten verbunden wird, so dass eine beidseitige_Sammlung der Minoritätsladungsträger erfolgt. Hierzu können Vorder- und Rückseite mit einer Grabenstruktur versehen werden, wobei vorteilhafterweise die Vorderseitengräben und damit die zwischen diesen sich erstreckenden Erhebungen senkrecht zu den Gräben und Erhebungen auf der Rückseite verlaufen und erstere nur auf jeweils einer Grabenflanke mit Minoritätsträger sammelnden Kontakten versehen sind.

Die Vorderseite sollte, insbesondere bei ausschließlich rückseitig sammelnden Anordnungen, eine sehr niedrige Oberflächenrekombmationsgeschwindigkeit besitzen. Vorzugsweise wird dies durch die Aufbringung einer Passivierungsschicht sichergestellt, die ggfs. gleichzeitig als Antireflexschicht dient. Hierfür eignet sich das im Plasma mit Hilfe chemischer Dampfabscheidung (CVD) z.B. durch Reaktion von SiH₄ und NH₃ hergestellte sogenannte Plasmasiliziumnitrid, bei welchem die Oberflächenzustände des Halbleiters durch Wasserstoff abgesättigt werden. Auch kommen CVD-SiO₂ und Al₂O₃ in Frage.

Für die Passivierung der Halbleiteroberfläche auf Vorder- und Rückseite eignet sich auch in Plasma hergestelltes und Wasserstoff enthaltendes amorphes Silizium (a-Si:H). Dies kann n-_oder p- dotiert oder undotiert sein. Eine Mehrfachschicht als Passivierungsschichtsystem sollte zur Vermeidung einer Inversionsschicht in dem Halbleitermaterial zur Anwendung gelangen. Dabei sollte substratseitig eine Schicht aus amorphem Si und auf dieser z. B. eine SiN, Plasma-SiN oder SiO₂-Schicht verlaufen.

Die Reihenfolge einer sehr dünnen eigenleitenden a-Si:H Schicht auf kristallinem Silizium, überdeckt mit einer p- oder n-dotierten a-Si:H Schicht wirkt sehr gut passivierend. Über eine darüber liegende TCO Schicht können die Ladungsträger zu den Kontakten (Kontaktfingern) geführt werden. Das durch thermische Reaktion von Sauerstoff und Silizium erzeugte SiO₂ kann ebenfalls als sehr gute Passivierungsschicht dienen, erfordert aber sehr hohe Temperaturen um 1000°C (bei SiN genügen 400°C - 600°C). Die erforderliche sehr niedrige optische Reflexion erreicht man durch eine Optimierung der Passivienmgsschicht als Antireflexschicht sowie durch eine geeignete Textur (Pyramiden u. dgl.) der Oberfläche. Vorteilhafterweise kann auch an der Vorderseite eine sog. floating junction (n⁺ - oder p⁺-Schicht) erzeugt und mit einer Antireflex- bzw. Passivierungsschicht bedeckt werden.

Bei der erfindungsgemäßen Solarzelle liegt auf einer Seite ein System von ineinandergreifenden, vorzugsweise linearen Emitter- und Basiskontakten (Fingern) vor. Hinsichtlich der Anbringung eines oder mehrerer Sammelstege sowohl zur lokalen Kontaktierung aller Minoritätsladungsträgerkontakte (Emitter) als auch der Majoritätsladungsträgerkontakte (Basis) ist anzumerken, dass nach eventueller vorheriger bereichsweiser Entfernung der Passivierungsschicht von den ersten und zweiten Kontakten (Kontaktfingern) der jeweilige Sammelsteg (Busbar) senkrecht zu den Metallfingern über die Gräben und Erhebungen verlaufend in Form eines schmalen Metallbandes aufgebracht wird. Die leitfähige Verbindung des Sammelstegs (Metallbandes) mit den Kontaktfingern erfolgt erfindungsgemäß durch einen zuvor auf die Solarzelle oder auf die Metallbänder entweder durchgehend oder punktweise aufgebrachten leitfähigen Klebstoff, der bei relativ niedrigen Temperaturen (etwa bis max. 400°C) ausgehärtet wird (Conductive Adhesive Joining Technology). Die Metallbänder dienen sowohl als Sammelstege (Busbar) als auch zur Verbindung einzelner Zellen untereinander. Die Verbindung des Sammelstegs mit den Kontaktfingern kann aber auch durch einen Lötprozess erfolgen.

Für die erfindungsgemäße Rückseitenstruktur, bei der Sammelstegpaare verschiedener Polarität auf einer Seite der Solarzelle verlaufen, können zur Vereinfachung der Kontaktierung und Verbindung der Zellen flexible Folien oder Platten verwendet werden, auf denen die Verdrahtungstruktur in Form der die jeweiligen Sammel- und Verbindungsstege bildenden metallischen Leiterbahnen aufgedruckt ist. Die Solarzellen werden nach lokaler_Auftragung des leitfähigen Klebers auf die Solarzelle oder auf die gedruckten Leiterbahnen auf diesen Leiterplatten oder -folien befestigt. Der Kleber besteht meist aus in einer Epoxymatrix sich befindlichen Metallpartikeln. Dieses erfindungsgemäße Verfahren bedeutet eine wesentliche Vereinfachung des Zusammenbaus der einzelnen Zellen zu Modulen und erlaubt eine problemlose Automatisierung der Modulherstellung.

Damit der jeweilige, senkrecht zu den Kontaktfingern verlaufende Sammelsteg (Metallband) nicht die zu beiden Seiten der Erhebungen sich auf unterschiedlichem Potential befindlichen ersten und zweiten Kontakte (Metallfinger) kurzschließt, damit also jeweils nur eine Gridstruktur kontaktiert wird, muß die jeweils andere Gridstruktur an der Stelle des Sammelsteges unterbrochen werden. Dies geschieht erfindungsgemäß vorzugsweise durch gezielte Abschattung, vorzugsweise durch einen dicht vor dem Halbleitersubstrat angeordneten Draht oder ein Metallbändchen, und zwar während der Schrägaufdampfung des Metalls zum Ausbilden der ersten und zweiten Kontakte. Dies ist von besonderem Vorteil, da im Vakuum die Metallaufdampfung gerichtet erfolgt und somit eine scharf begrenzte Unterbrechung der Metallfinger erfolgt.

Eine vorteilhafte Anwendung der Doppelkontaktanordnung für die Vorderseite ist für Dünnschichtsolarzellen auf Fremdsubstrat gegeben (R. Lüdemann et al, Proc. 26th IDEE DVSC (1997) S. 159). In diesem Falle kann das Halbleitermaterial direkt auf dem leitenden oder nicht leitenden Substrat unter optimalen Bedingungen aufgebracht werden, ohne auf das Vorhandensein eines Rückseitenmetalls zwischen Halbleiter und Substrat Rücksicht nehmen zu müssen. Um für Dünnschichtsolarzellen die erfindungsgemäße Anordnung auf der dem Licht zugewandten Seite realisieren zu können, wird die in den Figuren gezeigte Grabenstruktur in das Substrat eingebracht und hierauf gegebenenfalls nach Aufbringen einer Zwischenschicht die Halbleiterschicht hergestellt. Damit ist es auch für Dünnschichtsolarzellen möglich, sämtliche oben aufgeführten erfindungsgemäßen Vorteile zu nutzen, wie z. B. Aufbringung beider Kontakte durch Schrägaufdampfen im Vakuum, problemlose Trennung von Emitter- und Basisgebieten, im Falle des Siliziums Verwendung von kostengünstigem Aluminium als Kontaktmaterial, geringe Abschattung durch die Kontakte trotz Doppelkontaktstruktur, einfache Kontaktierung der Solarzellen auf einer Seite, integrierte Verschaltung etc.

Bei einer Dünnschichtsolarzelle wird dabei die Struktur (Erhebungen) nicht in dem Halbleitersubstrat selbst ausgebildet, da dieses auf einen entsprechend strukturierten Träger aufgebracht wird. Unabhängig hiervon können jedoch dann durch die Struktur vorgegebenen Erhebungen erste und zweite Kontakte auf das Substrat in zuvor beschriebener Art und Weise aufgebracht und ausgebildet werden, so dass die insoweit offenbarten Merkmale entsprechend für die Frontkontaktausbildung von Dünnschichtsolarzellen gilt, ohne dass es weiterer Erläuterungen bedarf.

## Patentansprüche

1. Solarzelle (10) umfassend ein Halbleitersubstrat (16) mit ersten und zweiten Kontakten (26, 28; 58, 60; 80, 82; 106, 108; 132) zum Sammeln und Ableiten von durch einfallende Strahlungsenergie in dem Halbleitersubstrat erzeugten Minoritäts- und Majoritätsladungsträgern, wobei zumindest bereichsweise rückseitige Fläche des Halbleitersubstrats parallel verlaufende, erste Graben begrenzende linien- bzw. stegartige Erhebungen (18, 50, 52, 54, 56, 78, 104, 130, 140) mit jeweils erster und zweiter Längsflanken (20, 22, 62, 64, 74, 76, 110, 112) aufweist, wobei die ersten und zweiten Kontakte auf der rückseitigen Fläche des Halbleitersubstrats beabstandet zueinander angeordnet sind,
wobei die erste und die zweite Längsflanke (20, 22, 62, 64, 74, 76, 110, 112) der Erhebung (18, 50, 52, 54, 56, 78, 104, 130; 140) über einen parallel oder in etwa parallel zur von dem Halbleitersubstrat (16) aufgespannten Ebene verlaufenden Außenabschnitt (24, 72, 86, 114) ineinander übergehen, wobei aufeinander folgende Erhebungen einen Graben mit Grabenboden begrenzen, **dadurch gekennzeichnet, dass** auf zumindest einigen der Erhebungen sich die ersten Kontakte (26, 58, 80, 106) auf den ersten Längsflanken (22, 62, 74, 110) der Erhebungen und die zweiten Kontakte (28, 60, 82, 108) auf den zweiten Längsflanken (20, 64, 76, 112) der Erhebungen erstrecken und dass die ersten und zweiten Kontakte zueinander sowohl graben- als auch außenabschnittsseitig zueinander beabstandet sind.

2. Solarzelle nach Anspruch 1,
**dadurch gekennzeichnet,**
**dass** die Erhebungen (18, 50, 52, 54, 56, 78, 104, 130, 140) im Schnitt eine U-, V- oder Sägezahn-Geometrie aufweisen, dass der Grabenboden zumindest abschnittsweise parallel oder in etwa parallel zu der von dem Halbleitersubstrat (16) aufgespannten Ebene verläuft und dass sich der jeweils erste bzw. zweite Kontakt (26, 58, 80, 106; 28 60, 82, 108) vorzugsweise bis hin zum äußeren Längsrand (102, 104) der ersten bzw. der zweiten Längsflanke (20, 22, 62, 64, 74, 76, 110, 112) der Erhebung sowie bis zu dem Grabenboden oder beabstandet zu diesem erstrecken.

3. Solarzelle nach Anspruch 1 oder 2,
**dadurch gekennzeichnet,**
**dass** das Halbleitersubstrat (16) zumindest in seiner unter dem ersten und/oder dem zweiten Kontakt (26, 28; 58, 60; 80, 82; 106, 108; 132) verlaufenden Oberfläche durch z. B. Diffusion, Ionenimplantation oder Legieren hochdotiert und/oder invertiert ist und/oder einen Heteroübergang aufweist.

4. Solarzelle nach zumindest Anspruch 1,
**dadurch gekennzeichnet,**
**dass** der Minoritätsladungsträger sammelnde erste Kontakt (58, 80, 106) ein Metall-/Halbleiterkontakt und/oder ein MIS (Metall-Isolator-Halbleiter)-Kontakt ist.

5. Solarzelle nach zumindest Anspruch 1,
**dadurch gekennzeichnet,**
**dass** der die Majoritätsladungsträger sammelnde zweite Kontakt ein unmittelbar auf dem Halbleitersubstrat (16) aufgebrachter Metallkontakt (28) und/oder ein auf hochdotiertem Halbleitersubstrat aufgebrachter Metallkontakt (60, 82, 108) ist.

6. Solarzelle nach zumindest einem der vorhergehenden Ansprüche,
**dadurch gekennzeichnet,**
**dass** sich entlang rückseitiger Fläche des Halbleitersubstrats (16) zumindest eine erste Passivierungsschicht (66, 96, 114) erstreckt.

7. Solarzelle nach zumindest einem der vorhergehenden Ansprüche,
**dadurch gekennzeichnet,**
**dass** die rückseitige Fläche des Halbleitersubstrats (16) eine Minoritätsladungsträger zu den diese sammelnden ersten Kontakten (58, 80, 106) leitende Minoritätsladungsträgerableitschicht (Emitterschicht) (94, 122) aufweist, die potentialmäßig zu den die Majoritätsladungsträger sammelnden (zweiten) Kontakten (60, 82, 108) getrennt ist.

8. Solarzelle nach zumindest einem der vorhergehenden Ansprüche,
**dadurch gekennzeichnet,**
**dass** die Emitterschicht (94, 122) im Oberflächenbereich des Halbleitersubstrats ausgebildet und/oder durch Ladungen in der ersten unmittelbar auf dem Halbleitersubstrat aufgebrachten Passivierungsschicht (96, 114) in der Oberfläche influenziert ist.

9. Solarzelle nach zumindest einem der vorhergehenden Ansprüche,
**dadurch gekennzeichnet,**
**dass** das Halbleitersubstrat (16) ein p-dotierter Halbleiter ist und die Emitterschicht (94, 122) eine hochdotierte n-Schicht (n⁺) und/oder eine durch positive Ladungen in der ersten Passivierungsschicht (96, 114) gebildete n-leitende Inversionsschicht bzw. ein Heteroübergang ist.

10. Solarzelle nach zumindest einem der vorhergehenden Ansprüche,
**dadurch gekennzeichnet,**
**dass** der erste und/oder zweite Kontakt (80, 82) bereichsweise auf zuvor mit Passivierungsmaterial abgedecktem und sodann von diesem freigelegten Abschnitt der ersten bzw. zweiten Längsflanke (74, 76) unmittelbar auf dieser oder auf einer Isolatorschicht (88) angeordnet sind.

11. Solarzelle nach zumindest einem der vorhergehenden Ansprüche,
**dadurch gekennzeichnet,**
**dass** die ersten und/oder zweiten Kontakte (26, 28; 58, 60; 80, 82; 106, 108; 132) linienförmig in Längsrichtung der ersten bzw. zweiten Längsflanken (20, 22, 62, 64, 74, 76, 110, 112) und auf diesen verlaufen.

12. Solarzelle nach zumindest einem der vorhergehenden Anspruche,
**dadurch gekennzeichnet,**
**dass** der erste und/oder zweite Kontakt (26, 28; 58, 60; 80, 82; 106, 108; 132) vorzugsweise in oberer längsrandseitiger Hälfte der ersten bzw. zweiten Längsflanke (20, 22, 62, 64, 74, 76, 110, 112) verlaufen.

13. Solarzelle nach zumindest einem der vorhergehenden Ansprüche,
**dadurch gekennzeichnet,**
**dass** zumindest die den ersten und/oder den zweiten Kontakt aufweisende erste bzw. zweite Längsflanke (138) eine Textur (144) aufweist.

14. Solarzelle nach zumindest einem der vorhergehenden Ansprüche,
**dadurch gekennzeichnet,**
**dass** die Textur durch pyramidenförmige Vorsprünge (144) gebildet ist.

15. Solarzelle nach zumindest einem der vorhergehenden Ansprüche,
**dadurch gekennzeichnet,**
**dass** die linear- bzw. streifenförmige die erste und zweite Längsflanke (74, 76, 110, 112) aufweisende Erhebung (78, 104, 130, 140) in ihrer halbleitersubstratseitigen Basis (55) eine Breite B aufweist, die kleiner oder gleich doppelter Diffusionslänge der Minoritätsladungsträger in dem Halbleitersubstrat (16) ist.

16. Solarzelle nach zumindest einem der vorhergehenden Ansprüche,
**dadurch gekennzeichnet,**
**dass** die von einer Erhebung (78, 104, 130, 140) ausgehenden ersten und zweiten Kontakte (80, 82; 106, 108; 132) mit ihren jeweiligen erhebungsbasisseitigen Längsrändern eine erste Ebene aufspannen und dass zwischen der ersten Ebene und der halbleiterschichtseitigen Basis (55) der Erhebung eine Schnittebene verläuft, die parallel zu der von dem Halbleitersubstrat aufgespannten Ebene verläuft, die Längsflanken (62, 64) schneidet und eine Breite B aufweist, die kleiner oder gleich doppelter Diffusionslänge der Minoritätsladungsträger in dem Halbleitersubstrat ist.

17. Solarzelle nach zumindest einem der vorhergehenden Ansprüche,
**dadurch gekennzeichnet,**
**dass** der Abstand zwischen Basismitte der Erhebung (78, 104, 130, 140) zum basisseitig verlaufenden Rand des zweiten Kontaktes (82,108) größer als halbe Breite der Basis (55) ist.

18. Solarzelle nach zumindest Anspruch 15 oder 16,
**dadurch gekennzeichnet,**
**dass** die Breite B der Basis (55) der Erhebung (56) bzw. die der Schnittebene (57) beträgt 5 µm ≤ B ≤ 2 mm.

19. Solarzelle nach zumindest einem der vorhergehenden Ansprüche,
**dadurch gekennzeichnet,**
**dass** das Halbleitersubstrat (16) außerhalb der Erhebung eine Dicke D mit 20 µm ≤ D ≤ 300 µm aufweist.

20. Solarzelle nach zumindest einem der vorhergehenden Ansprüche,
**dadurch gekennzeichnet,**
**dass** die Solarzelle (10) frontseitig durch parallel verlaufende Gräben strukturiert ist, die ihrerseits senkrecht zu den Erhebungen (18, 50, 52, 54, 56, 78, 104, 130, 140) auf der Rückseite (14) der Solarzelle verlaufen.

21. Solarzelle nach zumindest einem der vorhergehenden Ansprüche,
**dadurch gekennzeichnet,**
**dass** die Frontfläche der Solarzelle (10) eine Passivierungsschicht und/oder Antireflexionsschicht aufweist.

22. Solarzelle nach zumindest einem der vorhergehenden Ansprüche,
**dadurch gekennzeichnet,**
**dass** die Passivierungsschicht die Antireflexionsschicht ist.

23. Solarzelle nach zumindest einem der vorhergehenden Ansprüche,
**dadurch gekennzeichnet,**
**dass** die Passivierungsschicht (172) bzw. die Antireflexionsschicht aus Plasmasiliziumnitrid besteht.

24. Solarzelle nach zumindest einem der vorhergehenden Ansprüche,
**dadurch gekennzeichnet,**
**dass** die ersten und/oder zweiten parallel zueinander verlaufenden Kontakte (26, 28, 58, 60, 80, 82, 106, 108, 132) über jeweils einen senkrecht oder im Wesentlichen senkrecht zu diesen verlaufenden Sammelkontakt wie ein Metallband verbunden sind.

25. Solarzelle nach zumindest einem der vorhergehenden Ansprüche,
**dadurch gekennzeichnet,**
**dass** der Sammelkontakt mit den jeweiligen ersten bzw. zweiten Kontakten insbesondere über einen leitfähigen Klebstoff verbunden sind.

26. Solarzelle nach zumindest einem der vorhergehenden Ansprüche,
**dadurch geknnzeichnet,**
dass das Halbleitermaterial einkristallin, polykristallin oder amorph bzw. ein Element- oder Verbindungshalbleiter ist.

27. Solarzelle nach zumindest einem der vorhergehenden Ansprüche,
**dadurch geknnzeichnet,**
dass die Passivierungsschicht aus SiO₂, SiN, Al₂O₃, a-Si, a-Si:H besteht oder dieses enthält

28. Solarzelle nach zumindest einem der hervorgehenden Ansprüche,
**dadurch geknnzeichnet,**
dass die Passivierungsschicht aus einer Doppel- bzw. Mehrfachschicht mit substratseitig verlaufender a-Si- wie a-Si:H-Schicht besteht, über der zumindest eine Schicht aus vorzugsweise SiN, SiO₂ angordnet ist.

29. Solarzelle nach zumindest einem der hervorgehenden Ansprüche,
**dadurch geknnzeichnet,**
dass die Emitterschicht (94, 122) beabstandet zu dem zweiten Kontakt (82, 108) verläuft.

30. Solarzelle nach zumindest einem der hervorgehenden Ansprüche,
**dadurch gekennzeichnet,**
**dass** die Passivierungsschicht mittelbar oder unmittelbar einen Ladungsträgertransport zwischen erstem und zweitem Kontakt unterbindet oder im Wesentlichen unterbindet.

31. Solarzelle im Form einer Dünnschichtsolarzelle, bei der die ersten und zweiten Minoritäts- bzw. Majoritätsladungsträger sammelnden Kontakte auf Frontfläche des Halbleitersubstrats nach zumindest einem der vorhergehenden Ansprüche ausgebildet und/oder angeordnet sind.

32. Verfahren zur Herstellung einer Solarzelle nach zumindest einem der vorhergehenden Ansprüche, umfassend ein Halbleitersubstrat mit Vorder- und Rückseite, in welchem durch einfallende Strahlungsenergie Minoritäts- und Majoritätsladungsträger erzeugt werden, die über streifen- oder stegförmige erste und zweite Längsflanken aufweisende, erste Gräben begrenzende Erhebungen der rückseitigen Fläche des Halbleitersubstrats verlaufende erste und zweite Kontakte gesammelt und abgeleitet werden, wobei die ersten und zweiten elektrischen Kontakte unmittelbar auf der rückseitigen Fläche aufgebracht werden oder nach ganzflächigem oder weitgehend ganzflächigem Abdecken der rückseitigen Fläche mit einer Passivienmgsschicht und gegebenenfalls Entfernen von Bereichen der Passivierungsschicht und auf so freigelegte Bereiche des Halbleitersubstrats die ersten und zweiten elektrischen Kontakte aufgebracht werden,
wobei die ersten Gräben der Rückseite mit Grabenböden und die Erhebungen der Rückseite mit Außenabschnitten ausgebildet werden, die parallel zur von dem Halbleitersubstrat aufgespannten Ebene verlaufen, **dadurch gekennzeichnet, dass** auf zumindest einigen der Erhebungen die ersten elektrischen Kontakte auf den ersten Längsflanken der Erhebungen und die zweiten elektrischen Kontakte auf den zweiten Längsflanken der Erhebungen derart aufgebracht werden, dass die ersten und zweiten elektrischen Kontakte zueinander sowohl grabenbodenseitig als auch außenabschnittsseitig zueinander beabstandet sind.

33. Verfahren nach Anspruch 32,
**dadurch gekennzeichnet,**
**dass** der erste und/oder der zweite Kontakt durch Aufdampfen von Material unter einem Winkel α zur von von dem Halbleitersubstrat aufgespannter Ebene ausgehenden Normalen aufgebracht werden, wobei der Aufdampfwinkel α beträgt α ≠ 0° und α ≠ 90°.

34. Verfahren nach Anspruch 32 oder 33,
**dadurch gekennzeichnet,**
**dass** zur Dotierung der ersten und/oder der zweiten Längsflanke insbesondere unterhalb auf dieser auszubildendem ersten und/oder zweiten Kontakt maskierungsfrei Ionen derart implantiert werden, dass diese unter einem Auftreffwinkel β zur Normalen auftreffen, wobei der Auftreffwinkel β beträgt β ≠0° und β ≠ 90°.

35. Verfahren nach zumindest einem der Ansprüche 32 bis 34,
**dadurch gekennzeichnet,**
**dass** durch insbesondere lokales Erwärmen durch z.B. Laserstrahlen und/oder Lichtstrahlung der ersten und/oder zweiten Längsflanke eine hochdotierte Schicht im Halbleitersubstrat gebildet wird, wobei insbesondere flächige Erstreckung der hochdotierten Schicht gleich oder größer flächiger Erstreckung des ersten und/oder zweiten Kontakts auf dem Halbleitersubstrat ist, wobei insbesondere unter Ausnutzung durch die Erhebungen bewirkte Abschattung die erste und/oder zweite Flanke bestrahlt werden.

36. Verfahren nach zumindest einem der Ansprüche 32 bis 35,
**dadurch gekennzeichnet,**
**dass** die ersten Kontakte in einem ersten Schrägaufdampfprozessschritt und sodann die zweiten Kontakte in einem zweiten Aufdampfprozessschritt ausgebildet werden oder umgekehrt.

37. Verfahren nach zumindest einem der Ansprüche 32 bis 36,
**dadurch gekennzeichnet,**
**dass** die rückseitige Fläche des Halbleitersubstrats ganzflächig oder im Wesentlichen ganzflächig mit einer Passivierungsschicht abgedeckt wird und sodann vorzugsweise durch chemisch mechanisches Polieren zumindest die Passivierungsschicht und gegebenenfalls Halbleitermaterial im freien Längsrandbereich der Erhebungen sowie zwischen den Längsbereichen verlaufendem insbesondere plateauartigen Bereich zur Ausbildung des Außenabschnitts abgetragen werden.

38. Verfahren nach zumindest einem der Ansprüche 32 bis 37,
**dadurch gekennzeichnet,**
**dass** der erste und/oder der zweite Kontakt erhebungsbasisseitig gegebenenfalls bereichsweise auf der Passivierungsschicht verläuft.

39. Verfahren nach zumindest einem der Ansprüche 32 bis 38,
**dadurch gekennzeichnet,**
**dass** nach gegebenenfalls erforderlicher elektrischer Trennung der von einer gemeinsamen Erhebung ausgehenden ersten und zweiten Kontakte die rückseitige Fläche des Halbleitersubstrats mit einer weiteren einen Kurzschluss verhindernde Passivierungsschicht bzw. einem Passivierungsschichtsystem abgedeckt wird.

40. Verfahren nach zumindest einem der Ansprüche 32 bis 39,
**dadurch gekennzeichnet,**
**dass** während des Temperns durch Sauerstoffzugabe im Bereich der ersten Längsflanken der Erhebungen Tunneloxidschichten für die als MIS-Kontakte auszubildenden ersten Kontakte gebildet werden.

41. Verfahren nach zumindest einem der Ansprüche 32 bis 40,
**dadurch gekennzeichnet,**
**dass** bereichsweises Entfernen der ersten Passivierungsschicht bzw. von sich in entlang der ersten und zweiten Längsflanken erstreckenden Abschnitten der Erhebungen vorhandenem Metall durch insbesondere chemisch-mechanisches Polieren derart erfolgt, dass die Erhebungen auf Bewegungsrichtung eines translatorisch oder rotatorisch bewegten Polierelements derart ausgerichtet werden, dass diese parallel oder unter einem Winkel β mit 1 °C ≤ β ≤ 30 °C zueinander verlaufen.

42. Verfahren nach zumindest einem der Ansprüche 32 bis 41,
**dadurch gekennzeichnet,**
**dass** vorzugsweise vor Auftragen des Metalls zum Ausbilden der zweiten Kontakte im Bereich dieser ein lokales Rückseitenfeld durch zum Beispiel Bor-Implantation, Bor-Diffusion oder Legieren von z. B. Aluminium ausgebildet wird.

43. Verfahren nach zumindest einem der Ansprüche 32 bis 42,
**dadurch gekennzeichnet,**
**dass** in bzw. unter der ersten Passivierungsschicht eine Minoritätsladungsträger ableitende Schicht (Emitterschicht) ausgebildet wird, vorzugsweise durch Diffusion durch Dotieratome wie Phosphor.

44. Verfahren nach zumindest einem der Ansprüche 32 bis 43,
**dadurch gekennzeichnet,**
**dass** die Emitterschicht durch Erhöhung positiver Ladungsdichte, insbesondere durch Einbau alkalimetallhaltiger Substanzen in der ersten Passivierungsschicht wie Silizium-Nitridschicht ausgebildet wird, wobei die Erhöhung der Ladungsdichte vorzugsweise in einem Abstand d mit 1nm < d < 10 nm von der Halbleiteroberfläche vorliegt.

45. Verfahren nach zumindest einem Ansprüche 32 bis 44,
**dadurch gekennzeichnet,**
**dass** vor Ausbilden der ersten und/oder zweiten Kontakte Bereiche der Längsflanken senkrecht oder nahezu senkrecht zu deren Längserstreckung abgeschattet werden und auf so abgeschatteten Bereich ein die ersten oder die zweiten Kontakte elektrisch leitend verbindender weiterer Kontakt aufgebracht wird.

## Claims

1. Solar cell (10) including a semiconductor substrate (16) with first and second contacts (26, 28; 58, 60; 80, 82; 106, 108; 132) for collecting and discharging minority and majority charge carriers generated by incident radiation energy in the semiconductor substrate, whereby at least in sections the back surface of the semiconductor substrate has line or bar-like elevations (18, 50, 52, 54, 56, 78, 104, 130, 140) with respectively first and second longitudinal flank (20, 22, 62, 74, 76, 110, 112), said elevations running parallel and limiting first trenches, whereby the first and second contacts are arranged on the back surface of the semiconductor substrate spaced from one another, wherein the first and second longitudinal flank (20, 22, 62, 64, 74, 76, 110, 112) of the elevation (18, 50, 52, 54, 56, 78, 104, 130, 140) pass over into one another through an outer segment (24, 72, 86, 114) running parallel or approximately parallel to the plane defined by the semiconductor substrate (16), whereby successive elevations limit a trench with trench bottom,
**characterized in**
**that** on at least some of the elevations, the first contacts (26, 58, 80, 106) extend on the first longitudinal flanks (22, 62, 74, 110) of the elevations and the second contacts (28, 60, 82, 108) on the second longitudinal flanks (20, 64, 76, 112) of the elevations, and that the first and second contacts are spaced from one another on the trench side as well as on the exterior segment side.

2. Solar cell according to claim 1,
**characterized in**
**that** the elevations (18, 50, 52, 54, 56, 78, 104, 130, 140) have a U, V or sawtooth geometry in section, that the trench bottom runs at least segment-wise parallel or approximately parallel to the plane defined by the semiconductor substrate (16) and that the first or second contact (26, 58, 80, 106; 28, 60, 82, 108) preferably extend up to the outer longitudinal edge (102, 104) of the first or second longitudinal flank (20, 22, 62, 64, 74, 76, 110, 112) of the elevation as well as up to the trench bottom, or spaced from the latter.

3. Solar cell according to claim 1 or 2,
**characterized in**
**that** the semiconductor substrate (16) is highly doped by, for example, diffusion, ion implantation or alloying and/or is inverted and/or has a hetero-transition at least in its surface running under the first and/or the second contact (26, 28; 58, 60; 80, 82; 106, 108; 132).

4. Solar cell according to at least claim 1,
**characterized in**
**that** the contact (58, 80, 106) collecting the minority charge carriers is a metal/semiconductor and/or a MIS (metal insulator semiconductor) contact.

5. Solar cell according to at least claim 1,
**characterized in**
**that** the second contact collecting the majority charge carriers is a metal contact (28) applied directly on the semiconductor substrate (16) and/or a metal contact (60, 82, 108) applied to a highly doped semiconductor substrate.

6. Solar cell according to at least one of the preceding claims,
**characterized in**
**that** at least a first passivation layer (66, 96, 114) extends along the back surface of the semiconductor substrate (16).

7. Solar cell according to at least one of the preceding claims,
**characterized in**
**that** the back surface of the semiconductor substrate (16) has a minority charge carrier layer (emitter layer) (94, 122) conducting the minority charge carrier to the first contacts (58, 80, 106) collecting them, said emitter layer is separated with regard to potential from the (second) contacts (60, 82, 108) collecting majority charge carriers.

8. Solar cell according to at least one of the preceding claims,
**characterized in**
**that** the emitter layer (94, 122) is formed in the surface region of the semiconductor substrate and/or is influenced in the surface by charges in the first passivation layer (96, 114) applied directly on the semiconductor structure.

9. Solar cell according to at least one of the preceding claims,
**characterized in**
**that** the semiconductor substrate (16) is a p-type doped semiconductor and the emitter layer (94, 122) is a highly doped n-type layer (n⁺) and/or an n-type conducting inversion layer or a hetero-transition formed by positive charges in the first passivation layer (96, 114).

10. Solar cell according to at least one of the preceding claims,
**characterized in**
**that** the first and/or second contact (80, 82) are arranged regionally on the segment of the first or second longitudinal flank (74, 76), directly on the latter or on an insulator layer (88), previously covered with passivation material and then exposed from it.

11. Solar cell according to at least one of the preceding claims,
**characterized in**
**that** the first and/or second contacts (26, 28; 58, 60; 80, 82; 106, 108; 132) run linearly in the longitudinal direction of the first or second longitudinal flanks (20, 22, 62, 64, 74, 76, 110, 112) and on these.

12. Solar cell according to at least one of the preceding claims,
**characterized in**
**that** the first and/or second contact (26, 28; 58, 60; 80, 82; 106, 108; 132) preferably run in the upper longitudinal edge side half of the first or second longitudinal flank (20, 22, 62, 64, 74, 76, 110, 112).

13. Solar cell according to at least one of the preceding claims,
**characterized in**
**that** at least the first or second longitudinal flank (138) having the first and/or the second contact has a texture (144).

14. Solar cell according to at least one of the preceding claims,
**characterized in**
**that** the texture is formed by pyramid-like projections (144).

15. Solar cell according to at least one of the preceding claims,
**characterized in**
**that** the linear or strip-like elevation (78, 104, 130, 140) having the first and second longitudinal flank (74, 76, 110, 112) has a breadth B in its semiconductor substrate side base (55) which is smaller or equals double the diffusion length of the minority charge carrier in the semiconductor substrate (16).

16. Solar cell according to at least one of the preceding claims,
**characterized in**
**that** the first and second contacts (80, 82; 106, 108; 132) proceeding from an elevation (78, 104, 130, 140) with its respective elevation base side longitudinal edges define a first plane, and that between the first plane and the semiconductor side base (55) of the elevation a sectional plane (57) is running that extends in a plane running parallel to the plane defined by the semiconductor substrate and intersects the longitudinal flanks (62, 64), said sectional plane having a breadth B that is smaller than or equal to double the diffusion length of the minority charge carrier in the semiconductor substrate.

17. Solar cell according to at least one of the preceding claims,
**characterized in**
**that** the spacing between the base center of the elevation (78, 104, 130, 140) to the edge running on the base side of the second contact (82, 108) is greater than half the breadth of the basis (55).

18. Solar cell according to at least claim 15 or 16,
**characterized in**
**that** the breadth B of the base (55) of the elevation (56) or the sectional plane (57) is 5 µm ≤ B ≤ 2 mm.

19. Solar cell according to at least one of the preceding claims,
**characterized in**
**that** the semiconductor substrate (16) has a thickness D with 20 µm ≤ D ≤ 300 µm outside the elevation.

20. Solar cell according to at least one of the preceding claims,
**characterized in**
**that** the solar cell (10) is structured on the front side by parallel-running trenches that for their part run perpendicular to the elevations (18, 50, 52, 54, 56, 78, 104, 130, 140) on the back (14) of the solar cell.

21. Solar cell according to at least one of the preceding claims,
**characterized in**
**that** the front surface of the solar cell (10) has a passivation layer and/or anti-reflection layer.

22. Solar cell according to at least one of the preceding claims;
**characterized in**
**that** the passivation layer is the antireflection layer.

23. Solar cell according to at least one of the preceding claims,
**characterized in**
**that** the passivation layer (172) or the anti-reflection layer consists of plasma silicon nitride.

24. Solar cell according to at least one of the preceding claims,
**characterized in**
**that** the first and/or second contacts (26, 28, 58, 60, 80, 82, 106, 108, 132) running parallel to one another are connected through a collection contact such as a metal band respectively running perpendicular or basically perpendicular to these.

25. Solar cell according to at least one of the preceding claims,
**characterized in**
**that** the collector contact is connected with the respective first or second contacts, especially through a conductive adhesive.

26. Solar cell according to at least one of the preceding claims,
**characterized in**
**that** the semiconductor material is monocrystalline, polycrystalline or amorphous or is an element or semiconductor material.

27. Solar cell according to at least one of the preceding claims,
**characterized in**
**that** the passivation layer consists of or contains SiO₂, SiN, Al₂O₃, a-Si, a-Si:H.

28. Solar cell according to at least one of the preceding claims,
**characterized in**
**that** the passivation layer consists of a double or multiple layer with a-Si such as a-Si:H layer running on the substrate side over which at least one layer, preferably of SiN, SiO₂, is arranged.

29. Solar cell according to at least one of the preceding claims,
**characterized in**
**that** the emitter layer (94, 122) runs spaced in relation to the second contact (82, 108).

30. Solar cell according to at least one of the preceding claims,
**characterized in**
**that** the passivation layer indirectly or directly prevents a charge carrier transport between first and second contact or basically prevents it.

31. Solar cell in the form of a thin layer solar cell in which the first and second minority or majority charge carrier-collecting contacts are arranged on the front surface of the semiconductor substrate constructed and/or arranged according to at least one of the preceding claims.

32. Method for manufacturing a solar cell according to at least one of the preceding claims, comprising a semiconductor substrate with front and back side in which minority and majority charge carriers are generated through incident radiation energy, which are collected and discharged by first and second contacts running over elevations of the back surface of the semiconductor substrate delimiting first trenches having strip or bar-like first and second longitudinal flanks, whereby the first and second electrical contacts are applied directly on the back surface or are applied subsequent to all-over or largely all-over covering of the back surface with a passivation layer and if need be removal of regions of the passivation layer and onto regions of the semiconductor substrate thus exposed the first and second contacts are applied, wherein the first trenches of the back side are constructed with trench bottoms and elevations of the back with outer segments which run parallel to the plane defined by the semiconductor substrate,
**characterized in**
**that** on at least some of the elevations, the first electrical contacts are applied on the first longitudinal flanks of the elevations and the second electrical contacts on the second longitudinal flanks of the elevations such that the first and second electrical contacts are spaced from each other on the trench bottom side as well as on the outer segment side.

33. Method according to claim 32,
**characterized in**
**that** the first and/or second contact is applied by evaporation deposition of material under an angle α in relation to the normal proceeding from the plane defined by the semiconductor substrate, whereby the angle of evaporation deposition α is α ≠ 0° and α ≠ 90°.

34. Method according to claim 32 or 33,
**characterized in**
**that** ions are implanted free of masking for doping the first and/or second longitudinal flank, especially beneath the first and/or second contact to be constructed on this such that these arise under an angle of incidence β relative to the normal, whereby the angle of incidence β is β ≠ 0° and β ≠ 90°.

35. Method according to at least one of claims 32 to 34,
**characterized in**
**that** a highly doper layer is formed in the semiconductor substrate in particular by local heating by, for example, laser irradiation and/or light irradiation of the first and/or second longitudinal flank, whereby in particular areal extension of the highly doped layer is equal to or greater than the areal extension of the first and/or second contact on the semiconductor substrate, whereby the first and/or second flank are irradiated especially by using shadowing brought about by the elevations.

36. Method according to at least one of claims 32 to 35,
**characterized in**
**that** the first contacts are constructed in a first oblique evaporation deposition step and then the second contacts are constructed in a second evaporation deposition step or vice versa.

37. Method according to at least one of claims 32 to 36,
**characterized in**
**that** the back surface of the semiconductor substrate is covered all over the surface or basically all over the surface with a passivation layer and then, preferably through chemical-mechanical polishing, at least the passivation layer and if need be semiconductor material are worn away in the free longitudinal edge region of the elevations as well as especially in the plateau-like region running between the longitudinal regions to form the outer segment.

38. Method according to at least one of claims 32 to 37,
**characterized in**
**that** the first and/or second contact if need be runs regionally on the elevation base side of the passivation layer.

39. Method according to at least one of claims 32 to 38,
**characterized in**
**that** the back surface of the semiconductor substrate is covered with a further passivation layer or a passivation layer system preventing a short circuit after if need be necessary electrical separation of the first and second contacts proceeding from a common elevation.

40. Method according to at least one of claims 32 to 39,
**characterized in**
**that** tunnel oxide layers for the first contacts to be constructed as MIS contacts are formed during tempering by oxygen administration in the region of the first longitudinal flanks of the elevations.

41. Method according to at least one of the claims 32 to 40,
**characterized in**
**that** regional removal of the first passivation layer or of the metal present in segments of elevations extending along the first and second longitudinal flanks takes place in particular through chemical-mechanical polishing such that the elevations are oriented in the direction of motion of a polishing element with a translatory or rotary motion such that these run parallel to each other or under an angle β with 1°C ≤ β ≤ 30°C.

42. Method according to at least one of claims 32 to 41,
**characterized in**
**that** a local back field is formed, for example by boron implantation, boron diffusion or alloying with e.g. aluminum, preferably prior to applying the metal to construct the second contacts in the region of the latter.

43. Method according to at least one of claims 32 to 42,
**characterized in**
**that** a layer (emitter layer) discharging minority charge carriers is formed in or under the first passivation layer, preferably by diffusion by doping atoms such as phosphorus.

44. Method according to at least one of claims 32 to 43,
**characterized in**
**that** the emitter layer is formed by increasing the positive charge density, especially by incorporating alkaline metal-containing substances in the first passivation layer, such as a silicon nitride layer, whereby the increase of the charge density preferably lies at a distance d with 1 nm < d < 10 nm from the semiconductor surface.

45. Method according to at least one of claims 32 to 44,
**characterized in**
**that** regions of the longitudinal flanks are shadowed perpendicular or almost perpendicular to their longitudinal extension prior to constructing the first and/or second contacts, and an additional contact electrically conductively connecting the first or second electrical contacts is applied on such a shadowed region.

## Revendications

1. Cellule solaire (10) comprenant un substrat de semi-conducteur (16) avec des premiers et seconds contacts (26, 28 ; 58, 60 ; 80, 82 ; 106, 108 ; 132) destinés à collecter et décharger les porteurs de charge majoritaires et minoritaires produits par l'énergie rayonnante incidente dans le substrat de semi-conducteur, sachant que la surface arrière du substrat semi-conducteur présente au moins par endroits des élévations (18, 50, 52, 54, 56, 78, 104, 130, 140) en forme de lignes ou de barrettes s'étendant parallèlement, limitant des premières tranchées et présentant respectivement un premier et un second flanc longitudinal (20,22, 62,64, 74,76, 110,112), sachant que les premiers et seconds contacts sont disposés à distance les uns des autres sur la surface arrière du substrat de semi-conducteur, que les premiers et seconds flancs longitudinaux (20, 22, 62, 64, 74, 76, 110, 112) de l'élévation (18, 50, 52, 54, 56, 78, 104, 130, 140) se prolongent respectivement les uns dans les autres par l'intermédiaire d'une section extérieure (24, 72, 86, 114) s'étendant parallèlement ou approximativement parallèlement au plan formé par le substrat de semi-conducteur (16), et sachant que les élévations successives limitent une tranchée présentant un fond,
**caractérisée en ce**
**que** sur au moins certaines des élévations, les premiers contacts (26, 58, 80, 106) s'étendent sur les premiers flancs longitudinaux (22, 62, 74, 110) des élévations et les seconds contacts (28, 60, 82, 108) sur les seconds flancs longitudinaux (20, 64, 76, 112) des élévations, et que les premiers et seconds contacts sont à distance les uns des autres aussi bien du côté des tranchées que du côté de la section extérieure.

2. Cellule solaire selon la revendication 1,
**caractérisée en ce**
**que** les élévations (18, 50, 52, 54, 56, 78, 104, 130, 140) présentent en coupe une forme en U, V ou en dent de scie, que le fond de la tranchée s'étend, au moins par endroits, parallèlement ou approximativement parallèlement au plan formé par le substrat de semi-conducteur (16), et que respectivement le premier ou second contact (26, 58, 80, 106 ; 28, 60, 82, 108) s'étend de préférence jusqu'au côté longitudinal extérieur (102, 104) du premier ou second flanc longitudinal (20, 22, 62, 64, 74, 76, 110, 112) de l'élévation ainsi que jusqu'au fond de la tranchée ou à distance de celui-ci.

3. Cellule solaire selon la revendication 1 ou 2,
**caractérisée en ce**
**que** le substrat de semi-conducteur (16) est, au moins dans sa surface s'étendant au-dessous du premier et/ou du second contact (26, 28 ; 58, 60 ; 80, 82 ; 106, 108 ; 132), hautement dopé, par exemple par diffusion, implantation ionique ou alliage, et/ou inverti et/ou présente une hétérojonction.

4. Cellule solaire selon au moins la revendication 1,
**caractérisée en ce**
**que** le premier contact (58, 80, 106) collectant les porteurs de charge minoritaires est un contact métallique / contact de semi-conducteur et/ou un contact MIS (métal isolant de semi-conducteur).

5. Cellule solaire selon au moins la revendication 1,
**caractérisée en ce**
**que** le second contact collectant les porteurs de charge majoritaires est un contact métallique (28) disposé directement sur le substrat de semi-conducteur (16) et/ou un contact métallique (60, 82, 108) disposé sur un substrat de semi-conducteur hautement dopé.

6. Cellule solaire selon au moins une des revendications précédentes,
**caractérisée en ce**
**qu'**au moins une première couche de passivation (66, 96, 114) s'étend le long de la surface arrière du substrat de semi-conducteur (16).

7. Cellule solaire selon une des revendications précédentes,
**caractérisée en ce**
**que** la surface arrière du substrat de semi-conducteur (16) présente une couche de décharge de porteurs de charge minoritaires (couche d'émission) (94, 122) conduisant les porteurs de charge minoritaires vers les premiers contacts (58, 80, 106) les collectant, laquelle couche est séparée potentiellement des (seconds) contacts (60, 82, 108) collectant les porteurs de charge majoritaires.

8. Cellule solaire selon une des revendications précédentes,
**caractérisée en ce**
**que** la couche d'émission (94, 122) est formée dans la zone de surface du substrat de semi-conducteur et/ou influencée à la surface par des charges dans la première couche de passivation (96, 114) disposée immédiatement sur le substrat de semi-conducteur.

9. Cellule solaire selon au moins une des revendications précédentes,
**caractérisée en ce**
**que** le substrat de semi-conducteur (16) est un semi-conducteur dopé de type P et la couche d'émission (94, 122) une couche hautement dopée de type N (n⁺) et/ou une couche d'inversion conductrice de type N ou une hétérojonction formée par des charges positives dans la première couche de passivation (96, 114).

10. Cellule solaire selon au moins une des revendications précédentes,
**caractérisée en ce**
**que** le premier et/ou le second contact (80, 82) est (sont) disposé(s) par endroits sur une section du premier ou du second flanc longitudinal (74, 76), directement sur ce dernier ou sur une couche isolante (88), laquelle section est couverte au préalable de matériau de passivation et ensuite mise à nu.

11. Cellule solaire selon au moins une des revendications précédentes,
**caractérisée en ce**
**que** les premiers et/ou seconds contacts (26, 28 ; 58, 60 ; 80, 82 ; 106, 108 ; 132) s'étendent en forme de lignes dans le sens longitudinal des premiers ou seconds flancs longitudinaux (20, 22, 62, 64, 74, 76, 110, 112) et sur ceux-ci.

12. Cellule solaire selon au moins une des revendications précédentes,
**caractérisée en ce**
**que** le premier et/ou le second contact (26, 28 ; 58, 60 ; 80, 82 ; 106, 108 ; 132) s'étend(ent) de préférence dans la moitié supérieure du côté longitudinal du premier ou second flanc longitudinal (20, 22, 62, 64, 74, 76, 110, 112).

13. Cellule solaire selon au moins une des revendications précédentes,
**caractérisée en ce**
**qu'**au moins le premier ou second flanc longitudinal (138) présentant le premier et/ou le second contact présente une texture (144).

14. Cellule solaire selon au moins une des revendications précédentes,
**caractérisée en ce**
**que** la texture est formée par des saillies pyramidales (144).

15. Cellule solaire selon au moins une des revendications précédentes,
**caractérisée en ce**
**que** l'élévation (78, 104, 130, 140) en forme de lignes ou de rangées présentant le premier et second flanc longitudinal (74,76, 110, 112) présente dans sa base côté substrat de semi-conducteur (55) une largeur B, qui est inférieure ou égale à la longueur de diffusion double des porteurs de charge minoritaires dans le substrat de semi-conducteur (16).

16. Cellule solaire selon au moins une des revendications précédentes,
**caractérisée en ce**
**que** les premiers et seconds contacts (80, 82 ; 106, 108 ; 132) partant d'une élévation (78, 104, 130, 140) forment avec leurs bords longitudinaux respectifs côté base d'élévation un premier plan, et qu'entre le premier plan et la base côté couche de semi-conducteur (55) de l'élévation, un plan sécant (57), coupant les flancs longitudinaux (62, 64) et s'étendant parallèlement au plan formé par le substrat de semi-conducteur présente une largeur B inférieure ou égale à la longueur de diffusion double des porteurs de charge minoritaires dans le substrat de semi-conducteur.

17. Cellule solaire selon au moins une des revendications précédentes,
**caractérisée en ce**
**que** la distance entre le milieu de la base de l'élévation (78, 104, 130, 140) et le bord du second contact (82, 108) s'étendant du côté de la base est plus grande que la moitié de la largeur de la base (55).

18. Cellule solaire selon au moins la revendication 15 ou 16,
**caractérisée en ce**
**que** la largeur B de la base (55) de l'élévation (56) ou celle du niveau sécant (57) s'élève à 5 µm < B < 2 mm.

19. Cellule solaire selon au moins une des revendications précédentes,
**caractérisée en ce**
**que** le substrat de semi-conducteur (16) présente en dehors de l'élévation une épaisseur D de 20 µm < D < 300 µm.

20. Cellule solaire selon au moins une des revendications précédentes,
**caractérisée en ce**
**que** la cellule solaire (10) est, à l'avant, structurée par des tranchées parallèles qui s'étendent pour leur part verticalement par rapport aux élévations (18, 50, 52, 54, 56, 78, 104, 130, 140) sur la face arrière (14) de la cellule solaire.

21. Cellule solaire selon au moins une des revendications précédentes,
**caractérisée en ce**
**que** la surface avant de la cellule solaire (10) présente une couche de passivation et/ou une couche anti-réflexion.

22. Cellule solaire selon au moins une des revendications précédentes,
**caractérisée en ce**
**que** la couche de passivation est la couche anti-réflexion.

23. Cellule solaire selon au moins une des revendications précédentes,
**caractérisée en ce**
**que** la couche de passivation (172) ou la couche anti-réflexion est composée de nitrure de silicium par plasma.

24. Cellule solaire selon au moins une des revendications précédentes,
**caractérisée en ce**
**que** les premiers et/ou seconds contacts (26, 28, 58, 60, 80, 82, 106, 108, 132) s'étendant parallèlement l'un par rapport à l'autre sont reliés par l'intermédiaire de respectivement un contact collecteur, tel qu'une bande métallique, s'étendant verticalement ou essentiellement verticalement par rapport aux premiers et seconds contacts.

25. Cellule solaire selon au moins une des revendications précédentes,
**caractérisée en ce**
**que** le contact collecteur est relié aux premiers ou seconds contacts respectifs en particulier par l'intermédiaire d'une colle conductrice.

26. Cellule solaire selon au moins une des revendications précédentes,
**caractérisée en ce**
**que** le matériau du semi-conducteur est monocristallin, polycristallin ou amorphe, ou un semi-conducteur composé.

27. Cellule solaire selon au moins une des revendications précédentes,
**caractérisée en ce**
**que** la couche de passivation est composée de Si0₂, SiN, Al₂0₃, a-Si, a-Si:H ou en contient.

28. Cellule solaire selon au moins une des revendications précédentes,
**caractérisée en ce**
**que** la couche de passivation est composée d'une couche double ou multiple avec une couche a-Si telle qu'une couche a-Si:H s'étendant du côté du substrat sur laquelle est disposée au moins une couche composée de préférence de SiN, Si0₂.

29. Cellule solaire selon au moins une des revendications précédentes,
**caractérisée en ce**
**que** la couche d'émission (94, 122) s'étend à distance du second contact (82, 108).

30. Cellule solaire selon au moins une des revendications précédentes,
**caractérisée en ce**
**que** la couche de passivation empêche directement ou indirectement un transport des porteurs de charge entre le premier et le second contact ou l'empêche en grande partie.

31. Cellule solaire sous forme d'une cellule solaire à couche mince dans laquelle les contacts collectant les premiers et seconds porteurs de charge minoritaires ou majoritaires sur la surface avant du substrat de semi-conducteur sont conçus et/ou disposés selon au moins une des revendications précédentes.

32. Procédé de fabrication d'une cellule solaire selon au moins une des revendications précédentes, comprenant un substrat de semi-conducteur avec une face avant et une face arrière dans lequel les porteurs de charge minoritaires et majoritaires produits par l'énergie rayonnante incidente sont collectés et déchargés par des premiers et seconds contacts s'étendant sur la face arrière du substrat de semi-conducteur présentant des élévations limitant des premières tranchées et présentant des flancs longitudinaux en forme de lignes ou de barrettes, sachant que les premiers et seconds contacts électriques sont disposés directement sur la face arrière ou qu'ils sont disposés après recouvrement de toute la surface ou de pratiquement toute la surface avec une couche de passivation et le cas échéant retrait de parties de la couche de passivation, sur des zones découvertes du substrat de semi-conducteur, sachant que les premières tranchées de la face arrière présentent de par leur conception un fond, et les élévations de la face arrière des sections extérieures qui s'étendent parallèlement au plan formé par le substrat de semi-conducteur,
**caractérisé en ce**
**que**, sur au moins certaines des élévations, les premiers contacts électriques sont disposés sur les premiers flancs longitudinaux des élévations et les seconds contacts électriques sur les seconds flancs longitudinaux des élévations, et ce de telle manière que les premiers et seconds contacts électriques sont à distance les uns des autres aussi bien du côté du fond de la tranchée que du côté des sections extérieures.

33. Procédé selon la revendication 32,
**caractérisé en ce**
**que** le premier et/ou le second contact est (sont) appliqué(s) par évaporation de matériau à un angle α par rapport à la normale partant du plan formé par le substrat de semi-conducteur, sachant que l'angle d'évaporation α s'élève à α ≠ 0° et α ≠ 90°.

34. Procédé selon la revendication 32 ou 33,
**caractérisé en ce**
**que** des ions sont implantés sans masquage pour le dopage du premier et/ou du second flanc longitudinal, en particulier au-dessous du premier et/ou second contact à former sur le flanc, et ce de telle manière que ceux-ci se rencontrent à un angle d'incidence β par rapport à la normale, sachant que l'angle d'incidence β s'élève à β ≠ 0° et β ≠ 90°.

35. Procédé selon une des revendications 32 à 34,
**caractérisé en ce**
**qu'**une couche hautement dopée est formée dans le substrat de semi-conducteur en particulier par un réchauffement local par exemple par rayons laser et/ou radiation lumineuse du premier et/ou second flanc, sachant en particulier que l'étendue pleine de la couche hautement dopée est identique ou supérieure à l'étendue pleine du premier et/ou second contact sur le substrat de semi-conducteur, sachant que le premier et/ou second flanc est irradié en particulier en mettant à profit l'ombre créée par les élévations.

36. Procédé selon au moins une des revendications 32 à 35,
**caractérisé en ce**
**que** les premiers contacts sont formés lors d'une première étape d'évaporation oblique et les seconds contacts lors d'une seconde étape d'évaporation ou inversement.

37. Procédé selon au moins une des revendications 32 à 36,
**caractérisé en ce**
**que** la face arrière du substrat de semi-conducteur est recouverte sur toute sa surface ou pratiquement sur toute sa surface d'une couche de passivation et qu'ensuite au moins la couche de passivation et, le cas échéant, du matériau du semi-conducteur sont enlevés, de préférence par polissage chimico-mécanique, dans la partie découverte des bords longitudinaux des élévations ainsi que sur la partie en particulier en forme de plateau s'étendant entre les zones longitudinales, afin de former une section extérieure.

38. Procédé selon au moins une des revendications 32 à 37,
**caractérisé en ce**
**que** le premier et/ou le second contact s'étend(ent), du côté de la base des élévations et le cas échéant seulement en partie, sur la couche de passivation.

39. Procédé selon au moins une des revendications 32 à 38,
**caractérisé en ce**
**que** la surface arrière du substrat de semi-conducteur est recouverte, après le cas échéant une séparation électrique nécessaire des premiers et seconds contacts partant d'une même élévation, d'une autre couche de passivation ou d'un système de couche de passivation empêchant un court-circuit.

40. Procédé selon au moins une des revendications 32 à 39,
**caractérisé en ce**
**que** des couches d'oxyde tunnel pour les premiers contacts à concevoir sous forme de contacts MIS sont formées pendant le recuit par adjonction d'oxygène dans la zone des premiers flancs de l'élévation.

41. Procédé selon au moins une des revendications 32 à 40,
**caractérisé en ce**
**que** le retrait sur certaines parties de la première couche de passivation ou de métal présent sur les sections des élévations s'étendant le long des premiers et seconds flancs longitudinaux, en particulier par polissage chimico-mécanique a lieu de telle manière que les élévations sont orientées dans la direction de déplacement d'un élément de polissage se déplaçant de façon rotatoire ou translatoire, et ce de telle sorte que celles-ci s'étendent parallèlement ou sous un angle β de 1 °C ≤ β ≤ 30 °C les unes par rapport aux autres.

42. Procédé selon au moins une des revendications 32 à 41,
**caractérisé en ce**
**qu'**un champ de surface arrière local est formé par exemple par implantation de bore, diffusion de bore ou alliage par exemple d'aluminium, de préférence avant l'application du métal pour former les seconds contacts dans la région de ces derniers.

43. Procédé selon au moins une des revendications 32 à 42,
**caractérisé en ce**
**qu'**une couche (couche d'émission) déchargeant les porteurs de charge minoritaires est formée dans ou sous la première couche de passivation, de préférence par diffusion par atomes dopants tel que le phosphore.

44. Procédé selon au moins une des revendications 32 à 43,
**caractérisé en ce**
**que** la couche d'émission est formée par augmentation de la densité de charge positive, en particulier par intégration de substances contenant des métaux alcalins dans la première couche de passivation, telle qu'une couche de nitrure de silicium, sachant que l'augmentation de la densité de charge est située de préférence à une distance d de 1 nm < d < 10 nm de la surface du semi-conducteur.

45. Procédé selon au moins une des revendications 32 à 44,
**caractérisé en ce**
**que** des sections des flancs longitudinaux sont, avant la formation des premiers et/ou seconds contacts, ombragés verticalement ou pratiquement verticalement par rapport à leur étendue longitudinale et qu'un autre contact reliant de manière électroconductrice les premiers ou les seconds contacts est disposé sur la partie ainsi ombragée.
